(19) Europäisches Patentamt / European Patent Office / Office européen des brevets

(11) EP 2 958 186 A1

(12) **EUROPEAN PATENT APPLICATION**
published in accordance with Art. 153(4) EPC

(43) Date of publication:
**23.12.2015 Bulletin 2015/52**

(21) Application number: **14751280.0**

(22) Date of filing: **10.02.2014**

(51) Int Cl.:
***H01M 14/00*** (2006.01) ***H01L 31/04*** (2014.01)

(86) International application number:
**PCT/JP2014/053102**

(87) International publication number:
**WO 2014/126072 (21.08.2014 Gazette 2014/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **15.02.2013 JP 2013028447**

(71) Applicant: **Konica Minolta, Inc.**
**Tokyo 100-7015 (JP)**

(72) Inventors:
- **KAWASAKI, Hidekazu**
  **Tokyo 100-7015 (JP)**
- **MIWA, Hideya**
  **Tokyo 100-7015 (JP)**

(74) Representative: **Gille Hrabal**
**Brucknerstrasse 20**
**40593 Düsseldorf (DE)**

(54) **PHOTOELECTRIC CONVERSION ELEMENT AND SOLAR CELL COMPRISING SAME**

(57) The present invention has an object to provide a photoelectric conversion element exhibiting excellent photoelectric conversion efficiency. The photoelectric conversion element of the invention is a photoelectric conversion element which includes a substrate, a first electrode, a photoelectric conversion layer containing a semiconductor and a sensitizing dye, a charge transport layer and a second electrode and characterized in that the sensitizing dye is represented by the following Formula (1).

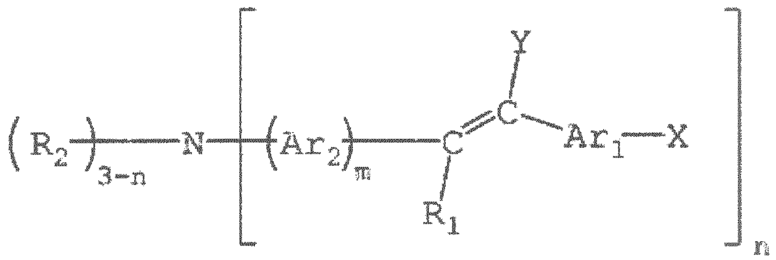

(1)

EP 2 958 186 A1

## Description

### Technical Field

The present invention relates to a photoelectric conversion element and a solar cell including the same.

### Background Art

In recent years, the utilization of sunlight which is unlimited and does not generate toxic substances has been vigorously investigated. As a method to utilize this sunlight that is a clean energy source, an application to a solar cell utilizing the photovoltaic effect is mentioned. The photovoltaic effect is a phenomenon that electromotive force is generated by irradiating a substance with light, and the use of a photoelectric conversion element containing a substance that is able to generate such electromotive force makes it possible to convert light energy into electrical energy. The solar cell which is practically used is mainly an inorganic solar cell using a photoelectric conversion element that contains an inorganic material such as monocrystalline silicon, polycrystalline silicon, amorphous silicon, cadmium telluride and copper indium selenide. However, since the inorganic material used is required to have high purity, the manufacturing process is complicated and thus the inorganic solar cell has a disadvantage such as high manufacturing cost.

As a method to solve this disadvantage of the inorganic solar cell, an organic solar cell which utilizes an organic material in the photoelectric conversion element has been proposed. As the organic material, for example, a Schottky type photoelectric conversion element in which a p-type organic semiconductor and a metal having a low work function come in contact with each other and a heterojunction type photoelectric conversion element in which a p-type organic semiconductor and an n-type inorganic semiconductor or a p-type organic semiconductor and an electron-accepting organic compound come in contact with each other are mentioned. As the organic semiconductor contained in these photoelectric conversion elements, a synthetic dye or pigment such as chlorophyll and perylene, a conductive macromolecular material such as polyacetylene or a composite material of these has been used. Incidentally, these materials are applied to a solar cell after being thinned by a vacuum deposition method, a casting method or a dipping method. However, the organic solar cell has a problem that the photoelectric conversion efficiency is low to be 1% or less although it is possible to lower the cost and to adopt a large area.

Under such a circumstance, a solar cell exhibiting favorable properties has been reported by Dr. Gratzel and colleagues of Switzerland. The solar cell is a dye-sensitized solar cell, in more detail, it is a liquid junction solar cell using a titanium oxide porous thin film that is spectrally sensitized by a ruthenium complex as a working electrode. The advantage of this solar cell is as follows. It is possible to use an inexpensive metal compound such as titanium oxide as a raw material of the semiconductor, and thus the material is not required to be highly purified as the inorganic material described above; and the dye sensitizing effect by a ruthenium complex has extended the utilizable wavelength of light to the visible light region. By virtue of this, the manufacturing cost of this dye-sensitized solar cell is inexpensive as compared to an inorganic solar cell, and it is possible to effectively convert the solar energy that contains a great amount of visible light component into the electrical energy.

However, the abundance of ruthenium on earth is significantly small and the annual production thereof is several tons. Hence, there is a problem that ruthenium is expensive, the supply amount thereof may be possibly insufficient and the like for the practical use of a dye-sensitized solar cell using ruthenium. In addition, a ruthenium complex exhibits a low time-dependent stability, and thus there is also a problem from the viewpoint of durability for the application thereof to a solar cell. Accordingly, there is a demand for a sensitizing dye which is inexpensive and suppliable in a great amount, and exhibits durability instead of a ruthenium complex.

Under such a circumstance, for example, in Patent Literature 1, a liquid junction solar cell using a phthalocyanine compound as a sensitizing dye replacing a ruthenium complex is disclosed. The phthalocyanine compound described in Patent Literature 1 is able to form a strong adsorptive bonding state with the surface of titanium dioxide (semiconductor) and thus the durability of the solar cell can be improved. However, the absorption wavelength region of the phthalocyanine compound described in Patent Literature 1 is narrow, and thus there is a problem that it is not possible to sufficiently absorb sunlight having a wide spectrum.

To cope with the problem, a method has been proposed in recent years in which a plurality of different sensitizing dyes are adsorbed on a semiconductor (for example, see Patent Literature 2). According to the method, the absorption wavelength region can be extended to a longer wavelength region by applying a plurality of sensitizing dyes, but the adsorptive force between the sensitizing dye and the semiconductor is weak and thus sufficient performance cannot be obtained.

## Citation List

### Patent Literature

Patent Literature 1: JP 9-199744 A
Patent Literature 2: JP 2006-185911 A

## Summary of Invention

### Technical Problem

As described above, the photoelectric conversion elements which have been reported so far have a problem that the light absorption wavelength region of the sensitizing dye is narrow. In consideration of application to a solar cell, there is a demand for a photoelectric conversion element which is able to efficiently utilize sunlight having a wide spectrum and is usable for a long period of time.

In view of such a circumstance, an object of the invention is to provide a photoelectric conversion element exhibiting excellent photoelectric conversion efficiency.

### Solution to Problem

The present inventors have conducted intensive studies, and as a result, have found out that the photoelectric conversion efficiency of a photoelectric conversion element is significantly improved by applying a sensitizing dye having a specific structure to the photoelectric conversion element, whereby the invention has been completed.

In other words, in order to realize at least one of the above objects, the photoelectric conversion element that reflects one aspect of the invention is a photoelectric conversion element including:

a substrate;
a first electrode;
a photoelectric conversion layer containing a semiconductor and a sensitizing dye;
a charge transport layer; and
a second electrode, in which
the sensitizing dye is represented by the following Formula (1):

[Chem. 1]

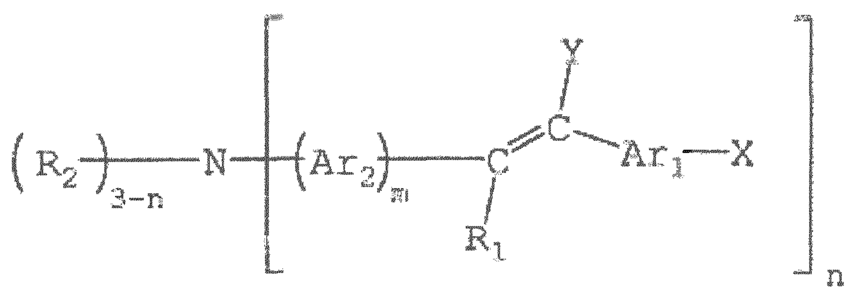

(1)

In Formula (1),

$Ar_1$ represents a substituted or unsubstituted divalent aromatic group or heterocyclic group;
X represents a carboxylic acid group (-C(=O)(OH)), a sulfonic acid group ($-S(=O)_2(OH)$), a phosphoric acid group ($-O-P(=O)(OH)_2$) or a phosphinic acid group ($-PR_a(=O)(OH)$, $R_a$ represents an alkyl group having 1 to 24 carbon atoms);
Y represents a cyano group, a nitro group, a halogen atom, $-COR_b$, $-COOR_b$ or $-S (= O)_2R_b$ (wherein $R_b$ represents a hydrogen atom, a substituted or unsubstituted alkyl group having 1 to 24 carbon atoms, a substituted or unsubstituted alkenyl group having 2 to 24 carbon atoms, a substituted or unsubstituted alkynyl group having 2 to 24 carbon atoms, a substituted or unsubstituted aryl group having 6 to 24 carbon atoms, a substituted or unsubstituted

acyl group having 1 to 24 or a substituted or unsubstituted heterocyclic group or amino group);
$R_1$'s each independently represent a hydrogen atom or a substituted or unsubstituted alkyl group having 1 to 24 carbon atoms;
$Ar_2$'s each independently represent a divalent aromatic ring-containing group or heterocyclic ring-containing group;
m represents an integer of 0 or more;
$R_2$'s each independently represent a. substituted or unsubstituted alkyl group having 1 to 24 carbon atoms, a substituted or unsubstituted cycloalkyl group having from 3 to 24 carbon atoms, a substituted or unsubstituted alkenyl group having 2 to 24 carbon atoms, a substituted or unsubstituted alkynyl group having 2 to 24 carbon atoms, a substituted or unsubstituted hydrocarbon ring-containing group having 6 to 24 carbon atoms or a substituted or unsubstituted heterocyclic ring-containing group;
n represents 2 or 3; and
$Ar_1$ and $Ar_2$ at each end of the carbon-carbon double bond may be in either a cis relation or a trans relation.

**Brief Description of Drawings**

Fig. 1 is a cross-sectional view which schematically illustrates a photoelectric conversion element according to an embodiment of the invention. In Fig. 1, 1 denotes a substrate; 2 denotes a first electrode; 3 denotes a barrier layer; 4 denotes a sensitizing dye; 5 denotes a semiconductor; 6 denotes a photoelectric conversion layer; 7 denotes a charge transport layer; 8 denotes a second electrode; 9 denotes sunlight; and 10 denotes a photoelectric conversion element, respectively.

**Description of Embodiment**

The photoelectric conversion element according to the invention includes a substrate, a first electrode, a photoelectric conversion layer containing a semiconductor and a sensitizing dye, a charge transport layer and a second electrode and characterized in that the sensitizing dye is represented by Formula (1) above. In other words, in the invention, it is possible to achieve high photoelectric conversion efficiency by using a sensitizing dye having the following partial structure (a):

[Chem. 2]

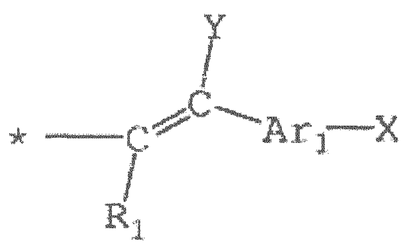

(a)

as represented by Formula (1) above as the sensitizing dye. The mechanism to exhibit such an effect is not clear, but it can be presumed as follows. Meanwhile, the invention is not intended to be limited by the following presumption.

In a compound of Formula (1), the steric repulsion in the vicinity of X that is the adsorption site onto an oxide semiconductor decreases as $Ar_1$ is present and thus it is possible to increase the adsorption amount of a dye onto the semiconductor. In addition, with regard to X and Y which are considered to be the charge injection site into the oxide semiconductor, Y is disposed at a position closer to a donor part (tertiary amine backbone moiety) and X is disposed at a position near the end of the conjugation from the donor part (tertiary amine backbone moiety). In other words, the charge injection into the oxide semiconductor can be reliably performed as X and Y are present apart from each other, and thus the conversion efficiency is improved. In addition, the conjugation length is extended by the presence of $Ar_1$, thus the resonance stability is improved, and the endurance stability is improved. Hence, the photoelectric conversion element which is formed using a sensitizing dye having a specific structure represented by Chemical Formula (1) is considered to exhibit excellent photoelectric conversion efficiency.

Consequently, by the invention, it is possible to provide a photoelectric conversion element exhibiting excellent photoelectric conversion efficiency and a solar cell.

Hereinafter, embodiments of the invention will be described.

[Photoelectric conversion element]

The photoelectric conversion element of the invention will be described with reference to Fig. 1. Fig. 1 is a cross-sectional view which schematically illustrates a photoelectric conversion element according to an embodiment of the invention. As illustrated in Fig. 1, a photoelectric conversion element 10 has a configuration to be formed by sequentially laminating a substrate 1, a first electrode 2, a barrier layer 3, a photoelectric conversion layer 6, a charge transport layer 7 and a second electrode 8. Here, the photoelectric conversion layer 6 contains a semiconductor 5 and a sensitizing dye 4. As illustrated in Fig. 1, it is preferable to have a barrier layer 3 between the first electrode 2 and the photoelectric conversion layer 6 for the purpose of preventing short circuit, sealing and the like. Meanwhile, in Fig. 1, sunlight enters from the direction indicated by an arrow 9 at the lower part of the drawing but the invention is not limited to this embodiment, and sunlight may be incident from the upper part of the drawing.
Next, a preferred embodiment of the method for manufacturing a photoelectric conversion element according to the invention will be described. First, the first electrode 2 is formed on the substrate 1, the barrier layer 3 is formed thereon, a semiconductor layer composed of the semiconductor 5 is formed on the barrier layer 3, and the sensitizing dye 4 is adsorbed on the surface of the semiconductor to form the photoelectric conversion layer 6. Thereafter, the charge transport layer 7 is formed on the photoelectric conversion layer 6. At this time, the charge transport layer 7 penetrates into the photoelectric conversion layer 6 composed of the semiconductor 5 supporting the sensitizing dye 4 and is present thereon. Thereafter, the second electrode 8 is formed on the charge transport layer 7. It is possible to take out current by attaching a terminal to the first electrode 2 and the second electrode 8.
Hereinafter, the respective members of the photoelectric conversion element of the invention will be described.

[Substrate]

The substrate plays a role as a member to be coated by a coating liquid in the case of forming the electrode by a coating method. In a case in which light is incident from the substrate side, the substrate is preferably a member which is able to transmit this light, that is, transparent with respect to the wavelength of light to be photoelectrically converted. Specifically, the light transmittance is preferably 10% or more, more preferably 50% or more and even more preferably from 80% to 100% from the viewpoint of the photoelectric conversion efficiency. Meanwhile, in the present specification, the term "light transmittance" is intended to mean the total light transmittance in the visible light wavelength region measured by a method which conforms to the "test method of total light transmittance for plastic and transparent material" by JIS K 7361-1: 1997 (corresponding to ISO 13468-1: 1996).
It is possible to appropriately select the material, shape, structure, thickness, hardness and the like of the substrate from those known in the art, but it is preferable that the substrate have high optical transparency as described above.
As the material of the substrate, it is possible to use a substrate exhibiting rigidity and a substrate exhibiting flexibility. It may be possible to use a substrate exhibiting rigidity and a substrate exhibiting flexibility in combination.
The substrate exhibiting rigidity is not particularly limited, and it is possible to use those which are known in the art. Specific examples thereof may include a glass plate and an acrylic plate. It is preferable to use a glass plate among these from the viewpoint of heat resistance. The thickness of the substrate exhibiting rigidity is not particularly limited, but it is preferably from 0.1 to 100 mm and more preferably from 0.5 to 10 mm.
On the other hand, the substrate exhibiting flexibility is not particularly limited, and it is possible to use those which are known in the art. Specific examples thereof may include a polyester-based resin film such as polyethylene terephthalate (PET), polyethylene naphthalate and modified polyester; a polyolefin resin film such as polyethylene (PE), polypropylene (PP), polystyrene and cyclic olefin; a vinyl resin film such as polyvinyl chloride and polyvinylidene chloride; a polyvinyl acetal resin film such as polyvinyl butyral (PVB) ; a polyether ether ketone (PEEK) resin film; a polysulfone (PSF) resin film; a polyethersulfone (PES) resin film; a polycarbonate (PC) resin film; a polyamide resin film; a polyimide resin film; an acrylic resin film; and a triacetyl cellulose (TAC) resin film. It is preferable to use a resin film of which the transmittance at a wavelength (400 to 700 nm) in the visible region is 80% or more as the substrate particularly in consideration of utilizing solar energy. Examples of the resin film may include a biaxially oriented polyethylene terephthalate film, a biaxially oriented polyethylene naphthalate film, a polyethersulfone film and a polycarbonate film, and it is preferable to use a biaxially oriented polyethylene terephthalate film and a biaxially oriented polyethylene naphthalate film among these. Meanwhile, the thickness of the substrate exhibiting flexibility is not particularly limited, but it is preferably from 1 to 1000 $\mu$m and more preferably from 10 to 100 $\mu$m.
The substrate described above may be provided with surface treatment or an adhesion promoting layer in order to secure the wettability or adhesion property for the coating liquid. It is possible to use a technique known in the related art for the surface treatment or the adhesion promoting layer. It is possible to conduct the surface treatment, for example, by a surface activation treatment such as corona discharge treatment, flame treatment, ultraviolet treatment, high frequency treatment, glow discharge treatment, active plasma treatment and laser treatment. In addition, it is possible to

use a polyester, a polyamide, a polyurethane, a vinyl-based copolymer, a butadiene-based copolymer, an acrylic copolymer, a vinylidene-based copolymer and an epoxy-based copolymer as the adhesion promoting layer.

[First electrode]

The first electrode is disposed between the substrate and the photoelectric conversion layer. Here, the first electrode is provided on one surface to be opposite side to the light incident direction of the substrate. The light transmittance of the first electrode is preferably 10% or more, more preferably 50% or more and even more preferably from 80% to 100% from the viewpoint of the photoelectric conversion efficiency.

The material constituting the first electrode is not particularly limited, and it is possible to use a material known in the art. For example, a metal and an oxide thereof and a composite (doped) material containing at least one kind selected from the group consisting of Sn, Sb, F and Al can be used. Examples of the metal may include platinum, gold, silver, copper, aluminum, rhodium and indium, examples of the metal oxide may include $SnO_2$, CdO, ZnO, a CTO-based material ($CdSnO_3$, $Cd_2SnO_4$, $CdSnO_4$), $In_2O_3$ and $CdIn_2O_4$, and examples of the composite (doped) material may include Sn doped $In_2O_3$ (ITO), Sb doped $SnO_2$ and F doped $SnO_2$ (FTO). Among these, a preferred example of the metal may include silver, and a grid patterned film having an opening or a film coated with dispersed fine particles or nanowires is preferably used in order to provide optical transparency. In addition, a preferred example of the metal oxide may include a composite (doped) material obtained by adding one kind or two or more kinds selected from Sn, Sb, F and Al to the metal oxide mentioned above. More preferably, a conductive metal oxide such as Sn doped $In_2O_3$ (ITO), Sb doped $SnO_2$ and F doped $SnO_2$ (FTO) is preferably used, and FTO is even more preferable from the viewpoint of heat resistance.

The amount of the first electrode forming material coated on the substrate is not particularly limited, but it is preferably about from 1 to 100 g per 1 $m^2$ of the substrate. Meanwhile, in the present specification, the laminate composed of the substrate and the first electrode formed thereon is also referred to as a "conductive support".

The film thickness of the conductive support is not particularly limited, but it is preferably from 0.1 mm to 5 mm. It is preferable that the surface resistance of the conductive support be as low as possible. Specifically, the surface resistance is preferably 500 $\Omega/cm^2$ or less and more preferably 10 $\Omega/cm^2$ or less. Meanwhile, the lower limit of the surface resistance of the conductive support is not necessary to be particularly defined since the surface resistance is preferably as low as possible, but it is sufficiently 0.01 $\Omega/cm^2$ or more. The preferred range of the light transmittance of the conductive support is the same as the preferred range of the light transmittance of the substrate.

[Barrier layer]

The photoelectric conversion element of the invention preferably includes a barrier layer which has a membrane shape (layer shape) and positioned between the first electrode and the semiconductor layer as a short circuit preventing means.

The constituent material of the barrier layer is not particularly limited, but examples thereof may include zinc, niobium, tin, titanium, vanadium, indium, tungsten, tantalum, zirconium, molybdenum, manganese, iron, copper, nickel, iridium, rhodium, chromium, ruthenium or an oxide thereof, in addition, a perovskite such as strontium titanate, calcium titanate, barium titanate, magnesium titanate and strontium niobate, or a composite oxide or oxide mixture of these, and a combination of one kind or two or more kinds of various metal compounds such as CdS, CdSe, TiC, $Si_3N_4$, SiC and BN.

Particularly, in a case in which the charge transport layer is a p-type semiconductor, it is preferable to use those which have a smaller work function value than the charge transport layer and the Schottky type contact in the case of using a metal in the barrier layer. In addition, it is preferable to use those which are in an ohmic contact with the transparent conductive layer, and the energy level of the conductionband is lower than the semiconductor layer (photoelectric conversion layer) in the case of using a metal oxide in the barrier layer. At this time, it is also possible to improve the electron transfer efficiency from the semiconductor layer (photoelectric conversion layer) to the barrier layer by selecting an oxide. Among these, those which exhibit electrical conductivity equivalent to that of the semiconductor layer (photoelectric conversion layer) are preferable, and in particular, those which are mainly composed of titanium oxide are more preferable.

The structure of the barrier layer is not particularly limited, but it is preferably a film having a porous structure as the photoelectric conversion layer. However, the porosity of the barrier layer is preferably smaller than the porosity of the semiconductor layer (photoelectric conversion layer). Specifically, when the porosity of the barrier layer is set to C [% by volume] and the porosity of the semiconductor layer is set to D [% by volume], D/C is, for example, preferably approximately 1.1 or more, more preferably approximately 5 or more and even more preferably approximately 10 or more. Here, the upper limit of D/C is not necessary to be particularly defined since D/C is preferably as great as possible, but it is usually approximately 1000 or less. This makes it possible for each of the barrier layer and the semiconductor layer to more suitably exert its function.

More specifically, the porosity C of the barrier layer is, for example, preferably approximately 20% by volume

or less, more preferably approximately 5% by volume or less and even more preferably approximately 2% by volume or less. In other words, the barrier layer is preferably a dense layer. This makes it possible to further improve the effect described above. Here, the lower limit of the porosity C of the barrier layer is not necessary to be particularly defined since the porosity is preferably as small as possible, but it is usually approximately 0.05% by volume or more.

The average thickness (film thickness) of the barrier layer is, for example, preferably approximately from 0.01 to 10 μm and more preferably approximately from 0.03 to 7 μm. This makes it possible to further improve the effect described above.

[Photoelectric conversion layer]

The photoelectric conversion layer has a configuration to convert light energy into electrical energy by utilizing the photovoltaic effect. In the invention, the photoelectric conversion layer essentially contains a semiconductor and a sensitizing dye. In more detail, the photoelectric conversion layer has a structure in which a sensitizing dye is supported on the semiconductor layer containing a semiconductor.

(Semiconductor)

As the material of the semiconductor used in the semiconductor layer, it is possible to use a simple substance such as silicon and germanium, a compound having an element of the group 3 to group 5 and group 13 to group 15 in the periodic table (also referred to as the periodic table of elements), a metal chalcogenide (for example, an oxide, a sulfide, a selenide and the like), a metal nitride and the like. Specific examples of the metal chalcogenide may include an oxide of titanium, tin, zinc, iron, tungsten, zirconium, hafnium, strontium, indium, cerium, yttrium, lanthanum, vanadium, niobium or tantalum; a sulfide of cadmium, zinc, lead, silver, antimony or bismuth; a selenide of cadmium or lead; and a telluride of cadmium. In addition, examples of another material of the semiconductor may include a phosphorus compound of zinc, gallium, indium, cadmium and the like; a selenide of gallium-arsenic or copper-indium; a sulfide of copper-indium; and titanium nitride. In more detail, $TiO_2$, $SnO_2$, $Fe_2O_3$, $WO_3$, ZnO, $Nb_2O_5$, CdS, ZnS, PbS, $Bi_2S_3$, CdSe, CdTe, GaP, InP, GaAs, $CuInS_2$, $CuInSe_2$, $Ti_3N_4$ and the like are mentioned. Among these, it is preferable to use $TiO_2$, ZnO, $SnO_2$, $Fe_2O_3$, $WO_3$, $Nb_2O_5$, CdS, or PbS, it is more preferable to use $TiO_2$ or $Nb_2O_5$, and it is even more preferable to use $TiO_2$ (titanium dioxide). These materials may be used singly or in combination of two or more kinds. Examples of the form of a combination of two or more kinds may include a form to mix 20% by mass of titanium nitride ($Ti_3N_4$) with the titanium oxide semiconductor and a form of a zinc oxide/tin oxide composite described in J. Chem. Soc. Chem. Commun. , 15 (1999). Meanwhile, in the case of combining another semiconductor material with a metal oxide or a metal sulfide to use, the amount of another semiconductor material added is not particularly limited to the extent to which the effect according to the invention is not inhibited, but it is preferable that the weight ratio of another semiconductor material to the metal oxide or metal sulfide semiconductor be more than 0% and 30% or less. Meanwhile, the other semiconductor materials mentioned above may be used singly or two or more kinds of the semiconductors may be used concurrently.

The shape of the semiconductor is not particularly limited, and it may have an arbitrary shape such as a spherical shape, a cylindrical shape and a tubular shape. The size of the semiconductor is not also particularly limited, and the average particle size of the semiconductor is preferably from 1 to 5000 nm and more preferably from 2 to 500 nm, for example, in a case in which the semiconductor is spherical. Meanwhile, the "average particle size" of the semiconductor means an average particle size (average primary particle size) of the primary particle diameters when 100 or more samples are observed by an electron microscope.

The semiconductor may be subjected to surface treatment using an organic base. The organic base used for the surface treatment is not particularly limited, and examples thereof may include diarylamine, triarylamine, pyridine, 4-tert-butylpyridine, polyvinylpyridine, quinoline, piperidine, andamidine. The surface treatment is preferably conducted using pyridine, 4-tert-butylpyridine and polyvinylpyridine among these. The surface treatment method is not particularly limited, and a method known in the art can be used and the method can be appropriately changed by those skilled in the art if necessary. For example, the surface treatment of the semiconductor can be carried out by preparing an organic base, at this time the organic base is used as it is in the case of a liquid and a solution (organic base solution) is prepared by dissolving the solid organic base in an organic solvent in the case of a solid, and immersing the semiconductor according to the invention in the liquid organic base or the organic base solution at from 0 to 80°C for from 1 minute to 24 hours.

(Sensitizing dye)

The sensitizing dye has a function to be photoexcited to generate electromotive force at the time of light irradiation. The sensitizing dye is supported on the semiconductor by the sensitization treatment of the semiconductor

to be described below. The invention is characterized in that a compound represented by the following Chemical Formula (1) is used as the sensitizing dye. In the compound of Formula (1) of the invention, the steric repulsion in the vicinity of X that is the adsorption site onto the oxide semiconductor decreases as $Ar_1$ is present and thus it is possible to increase the adsorption amount of the dye onto the semiconductor. In addition, X and Y which are considered to be the charge injection site into the oxide semiconductor are present in distance from each other by the presence of $Ar_1$, and thus the charge injection into the oxide semiconductor can be efficiently performed and the conversion efficiency is improved. In addition, the conjugation length is extended by the presence of $Ar_1$, thus the resonance stability is improved, and the endurance stability is improved. Hence, it is considered that the use of the sensitizing dye of Formula (1) in which $Ar_1$ is present makes it possible to form a photoelectric conversion element capable of exerting excellent photoelectric conversion efficiency. Meanwhile, the invention is not intended to be limited to the above mechanism.

The above sensitizing dye is represented by the following Formula (1).

[Chem. 3]

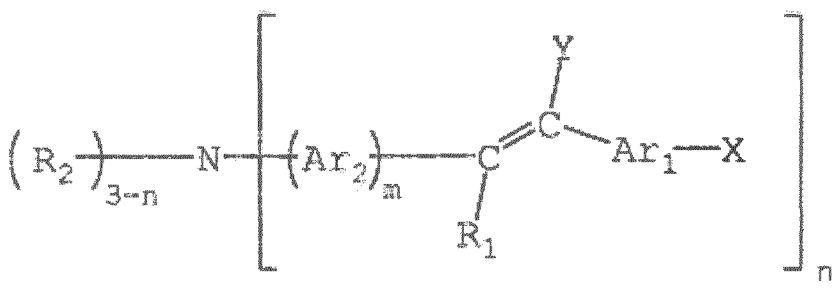

(1)

In Formula (1), $Ar_1$ represents a substituted or unsubstituted divalent aromatic group or heterocyclic group; X represents a carboxylic acid group (-C(=O)(OH)), a sulfonic acid group (-S=)(O)$_2$(OH)), a phosphoric acid group (-O-P(=O)(OH)$_2$) or a phosphinic acid group (-PR$_a$(=O)(OH), $R_a$ represents an alkyl group having 1 to 24 carbon atoms) ; Y represents a cyano group, a nitro group, a halogen atom, -COR$_b$, -COOR$_b$ or -S(=O)$_2$R$_b$ (wherein $R_b$ represents a hydrogen atom, a substituted or unsubstituted alkyl group having 1 to 24 carbon atoms, a substituted or unsubstituted alkenyl group having 2 to 24 carbon atoms, a substituted or unsubstituted alkynyl group having 2 to 24 carbon atoms , a substituted or unsubstituted aryl group having 6 to 24 carbon atoms, a substituted or unsubstituted acyl group having 1 to 24 or a substituted or unsubstituted heterocyclic group or amino group); $R_1$'s each independently represent a hydrogen atom or a substituted or unsubstituted alkyl group having 1 to 24 carbon atoms; $Ar_2$'s each independently represent a divalent aromatic ring-containing group or heterocyclic ring-containing group; m represents an integer of 0 or more; $R_2$'s each independently represent a substituted or unsubstituted alkyl group having 1 to 24 carbon atoms, a substituted or unsubstituted cycloalkyl group having from 3 to 24 carbon atoms, a substituted or unsubstituted alkenyl group having 2 to 24 carbon atoms, a substituted or unsubstituted alkynyl group having 2 to 24 carbon atoms, a substituted or unsubstituted hydrocarbon ring-containing group having 6 to 24 carbon atoms or a substituted or unsubstituted heterocyclic ring-containing group; n is 2 or 3; and $Ar_1$ and $Ar_2$ at each end of the carbon- carbon double bond may be in either a cis relation or a trans relation.

In Formula (1), $Ar_1$ represents a substituted or unsubstituted divalent aromatic group or heterocyclic group.

Here, the divalent aromatic group is those which are composed of a carbon atom and a hydrogen atom. Specifically, it is those which are derived from a benzene ring, a naphthalene ring and an anthracene ring.

The divalent heterocyclic group is not particularly limited as long as it is those which are composed of a carbon atom, a hydrogen atom and one or more heteroatoms selected from a nitrogen atom, an oxygen atom and a sulfur atom. Specifically, it is those which are derived from a thiophene ring, a dithienothiophene ring, a cyclopentadithiophene ring, a phenylthiophene ring, a diphenylthiophene ring, an imidazole ring, an oxazole ring, an isoxazole ring, a thiazole ring, a pyrrole ring, a furan ring, a benzofuran ring, an isobenzofuran ring, a coumarin ring (for example, 3,4-dihydrocoumarin), a benzimidazole ring, a benzoxazole ring, a rhodanine ring, a pyrazolone ring, an imidazolone ring, a pyran ring, a pyridine ring, a pyrazine ring, a pyrazole ring, a pyrimidine ring, a pyridazine ring, a triazine ring, a fluorene ring, a benzothiophene ring, a benzo(c) thiophene ring, a benzimidazole ring, a benzoxazole ring, a benzisoxazole ring, a benzothiazole ring, an indole ring, a phthalazine ring, a Shinanorin ring, a quinazoline ring, a carbazole ring, a carboline ring, a diazacarboline ring(a ring obtained by substituting any one of the carbon atoms of the carboline with a nitrogen atom), a 1,10-phenanthroline ring, a quinone ring, a rhodanine ring, a dirhodanine ring, a thiohydantoin ring, a pyrazolone ring and a pyrazoline ring. A plurality of these aromatic rings may be used in combination, and for example, there is a group derived from phenylpyridine (for example, 4-phenylpyridine), styryl-thiophene (for example, 2-styryl-thiophene),

2-(9H-fluoren-2-yl)thiophene, 2-phenyl-benzo[b]thiophene, a phenylbi thiophene ring, 1,1-diphenyl-4-phenyl)-1,3-butadiene, 1,4-diphenyl-1,3-butadiene, 4 -(phenylmethylene)-2,5-cyclohexadiene and a phenyldithienothiophene ring.

These divalent aromatic rings and heterocyclic groups may have a substituent, and as the substituent, there are a halogen atom (for example, fluorine, chlorine and bromine,), a substituted or unsubstituted linear or branched alkyl group having 1 to 24 carbon atoms (for example, a methyl group, an ethyl group, a propyl group, an isopropyl group, a n-butyl group, a sec-butyl group, a t-butyl group, an isobutyl group, a pentyl group, an isopentyl group, a neopentyl group, a hexyl group, a heptyl group, an octyl group, a nonyl group, a dodecyl group, an octadecyl group and a 3-ethylpentyl group), a hydroxyalkyl group (for example, a hydroxymethyl group and a hydroxyethyl group), an alkoxyalkyl group (for example, methoxyethyl group), an alkoxy group having from 1 to 18 carbon atoms (for example, a methoxy group, an ethoxy group, a propoxy group, an isopropoxy group, a butoxy group, a pentyloxy group, a hexyloxy group, a heptyloxy group, an octyloxy group and a nonyloxy group), an aryl group (for example, a phenyl group and a tolyl group), an alkenyl group (for example, a vinyl group and an allyl group), an amino group (for example, a dimethylamino group, a diethylamino group and a diphenylamino group) and a heterocyclic group (for example, a morpholinyl group and a furanyl group). Meanwhile, in the above, a group is not to be substituted with the same substituent. In other words, the alkyl group to be substituted is not substituted with an alkyl group. In addition, the above substituents may be linked to each other to form a ring. In other words, $Ar_1$ may be a divalent heterocyclic group derived from 3,4-ethylenedioxythiophene which is a thiophene ring substituted in the form linked to each other by two methoxy groups.

$Ar_1$ is preferably a group derived from a benzene ring, a thiophene ring, a furan ring and a pyrrole ring, more preferably a group derived from a benzene ring, a thiophene ring and even more preferably a group derived from a thiophene ring among these.

In Formula (1), X represents a carboxylic acid group (-C(=O)(OH)), a sulfonic acid group ($-S(=O)_2(OH)$), a phosphoric acid group ($-O-P(=O)(OH)_2$) or a phosphinic acid group ($-PR_a(=O)(OH)$, $R_a$ represents an alkyl group having 1 to 24 carbon atoms). X is preferably a carboxylic acid group and a phosphoric acid group and more preferably a carboxylic acid group among these.

In addition, in Formula (1), Y represents a cyano group (CN group), a nitro group ($NO_2$ group), a halogen atom (a fluorine atom, a chlorine atom, a bromine atom and an iodine atom), $-COR_b$, $-COOR_b$ or $-S(=O)_2R_b$. Here, $R_b$ represents a hydrogen atom, a substituted or unsubstituted alkyl group having 1 to 24 carbon atoms, a substituted or unsubstituted alkenyl group having 2 to 24 carbon atoms, a substituted or unsubstituted alkynyl group having 2 to 24 carbon atoms, a substituted or unsubstituted aryl group having 6 to 24 carbon atoms, a substituted or unsubstituted acyl group having 1 to 24 or a substituted or unsubstituted heterocyclic group or amino group.

Here, the alkyl group having 1 to 24 carbon atoms may be either linear or branched and it is not particularly limited, but examples thereof may include a methyl group, an ethyl group, a n-propyl group, an isopropyl group, a n-butyl group, an isobutyl group, a sec-butyl group, a tert-butyl group, a n-pentyl group, an isopentyl group, a tert-pentyl group, a neopentyl group, a 1,2-dimethylpropyl group, a n-hexyl group, an isohexyl group, a 1,3-dimethylbutyl group, a 1-isopropylpropyl group, a 1,2-dimethylbutyl group, a n-heptyl group, a 1,4-dimethylpentyl group, a 3-ethylpentyl group, a 2-methyl-1-isopropylpropyl group, a 1-ethyl-3-methylbutyl group, a n-octyl group, a 2-ethylhexyl group, a 3-methyl-1-isopropylbutyl group, a 2-methyl-1-isopropyl group, a 1-t-butyl-2-methylpropyl group, a n-nonyl group, a 3,5,5-trimethylhexyl group, a n-decyl group, an isodecyl group, a n-undecyl group, a 1-methyldecyl group, a n-dodecyl group, a n-tridecyl group, a n-tetradecyl group, a n-pentadecyl group, a n-hexadecyl group, a n-heptadecyl group, a n-octadecyl group, a n-nonadecyl group, a n-eicosyl group, a n-heneicosyl group, a n-docosyl group, a n-tricosyl group and a n-tetracosyl group. Among these, a linear or branched alkyl group having from 1 to 8 carbon atoms is preferable and a methyl group, an ethyl group, a n-hexyl and a n-octadecyl group are more preferable.

In addition, the alkenyl group having 2 to 24 carbon atoms may be either linear or branched and it is not particularly limited, but examples thereof may include a vinyl group, an allyl group, a 1-propenyl group, an isopropenyl group, a 1-butenyl group, a 2-butenyl group, a 3-butenyl group, a 1-pentenyl group, a 2-pentenyl group, a 3-pentenyl group, a 1-hexenyl group, a 2-hexenyl group, a 3-hexenyl group, a 1-heptenyl group, a 2-heptenyl group, a 5-heptenyl group, a 1-octenyl group, a 3-octenyl group and a 5-octenyl group. Among these, a linear or branched alkenyl group having from 2 to 18 carbon atoms is preferable and a 1-propenyl group is more preferable.

The alkynyl group having 2 to 24 carbon atoms may be either linear or branched, and it is not particularly limited, but examples thereof may include an acetylenyl group, a 1-propynyl group, a 2-propynyl group, a 1-butynyl group, a 2-butynyl group, a 3-butynyl group, a 1-pentynyl group, a 2-pentynyl group, a 3-pentynyl group, a 1-hexynyl group, a 2-hexynyl group, a 3-hexynyl group, a 1-heptynyl group, a 2-heptynyl group, a 5-heptynyl group, a 1-octynyl group, a 3-octynyl group and a 5-octynyl group.

The aryl group having 6 to 24 carbon atoms is not particularly limited, but examples thereof may include a phenyl group, a naphthyl group, a biphenyl group, a fluorenyl group, an anthryl group, a pyrenyl group, an azulenyl group, an acenaphthylenyl group, a terphenyl group and a phenanthryl group. Among these, a phenyl group, a biphenyl group and a fluorenyl group are preferable and a phenyl group and a fluorenyl group are more preferable.

The acyl group having 1 to 24 carbon atoms may be either linear or branched and it is not particularly limited,

but examples thereof may include a formyl group, an acetyl group, an ethylcarbonyl group, a propylcarbonyl group, a pentylcarbonyl group, a cyclohexylcarbonyl group, an octylcarbonyl group, a 2-ethylhexylcarbonyl group, a dodecylcarbonyl group, a phenylcarbonyl group, a naphthylcarbonyl group, and a pyridylcarbonyl group. Among these, a linear or branched acyl group having from 2 to 18 carbon atoms is preferable and an acetyl group is more preferable.

Examples of the heterocyclic group may include a monovalent group derived from a saturated or unsaturated cyclic compound containing from 1 to 3 hetero atoms selected from a nitrogen atom, an oxygen atom and a sulfur atom. Although it is not limited to the following groups, specific examples thereof may include a morpholinyl group, an oxazolidyl group, a furanyl group, a pyridyl group, a pyrimidinyl group, a furyl group, a pyrrolyl group, a pyrrolidyl group, an imidazolyl group, an imidazolidyl group, a benzimidazolyl group, a pyrazolyl group, a pyrazinyl group, a triazolyl group (for example, a 1,2,4-triazol-1-yl group and a 1,2,3-triazol-1-yl group), an oxazolyl group, a benzoxazolyl group, a thiazolyl group, an isoxazolyl group, an isothiazolyl group, a furazanyl group, a thienyl group, a quinolyl group, a benzofuryl group, a dibenzofuryl group, a benzothienyl group, a dibenzothienyl group, an indolyl group, a carbazolyl group, a carbolinyl group, a diazacarbazolyl group (indicating a group obtained by substituting one of the carbon atoms constituting the carboline ring with a nitrogen atom), a quinoxalinyl group, a pyridazinyl group, a triazinyl group, a quinazolinyl group and a phthalazinyl group.

The amino group is not particularly limited, and examples thereof may include an amino group ($-NH_2$), a dimethylamino group, a dimethylamino group and a diphenylamino group.

Y is preferably a cyano group, a nitro group, $-COOR_b$ ($R_b$ represents a linear or branched alkyl group having from 1 to 8 carbon atoms) and $-S(=O)_2R_b$ ($R_b$ represents a linear or branched alkyl group having from 1 to 8 carbon atoms) and more preferably a cyano group among these.

In Formula (1), $R_1$'s each independently represent a hydrogen atom or a substituted or unsubstituted alkyl group having 1 to 24 carbon atoms. The alkyl group having 1 to 24 carbon atoms is as described above. Among these, $R_1$ is preferably a hydrogen atom or a linear or branched alkyl group having from 1 to 8 carbon atoms and more preferably a hydrogen atom.

In Formula (1), $Ar_2$'s each independently represent a divalent aromatic ring-containing group or heterocyclic ring-containing group and m represents an integer of 0 or more.

The divalent aromatic ring-containing group is not particularly limited as long as it is composed of a carbon atom and a hydrogen atom. Specifically, it is those which are derived from a benzene ring, a naphthalene ring and an anthracene ring. A plurality of these aromatic rings may be used in combination, and for example, there is a group derived from a biphenylene group, a terphenylene group, a fluorenylene group, a bithiophene group, a 4-thienylphenylene group and a diphenylstyryl group, and further, stilbene, 4-phenylmethylene-2,5-cyclohexadiene, triphenylethene (for example, 1,1,2-triphenylethene) and fluorene. These aromatic rings may have a substituent, and as the substituent, there are a halogen atom (for example, fluorine, chlorine and bromine), a substituted or unsubstituted linear or branched alkyl group having 1 to 24 carbon atoms (for example, a methyl group, an ethyl group, a t-butyl group, an isobutyl group, a dodecyl group, an octadecyl group, a 3-ethylpentyl group), a hydroxyalkyl group (for example, a hydroxymethyl group and a hydroxyethyl group), an alkoxyalkyl group (for example, a methoxyethyl group), an alkoxy group having from 1 to 18 carbon atoms (for example, a methoxy group, an ethoxy group, an ethoxy group, a propoxy group, an isopropoxy group, a butoxy group, a pentyloxy group and a hexyloxy group), an aryl group (for example, a phenyl group and a tolyl group), an alkenyl group (for example, a vinyl group and an allyl group), an amino group (for example, a dimethylamino group, a diethylamino group and a diphenylamino group), a heterocyclic group (for example, a morpholinyl group and a furanyl group).

$Ar_2$ is preferably a group derived from a benzene ring, styrene, stilbene, triphenylethene (for example, a 1,1,2-triphenylethene) and fluorene, more preferably a group derived from a benzene ring, styrene, stilbene, triphenylethene (for example, a 1,1,2-triphenylethene) and fluorine and even more preferably a group (that is, a phenylene group) derived from a benzene ring among these.

The divalent heterocyclic ring-containing group is not particularly limited as long as it is those which are composed of a carbon atom, a hydrogen atom and one or more hetero atoms selected from a nitrogen atom, an oxygen atom and a sulfur atom. Specifically, it is those which are derived from a thiophene ring, a dithienothiophene ring, a cyclopentadithiophene ring, a phenylthiophene ring, a diphenylthiophene ring, an imidazole ring, an oxazole ring, an isoxazole ring, a thiazole ring, a pyrrole ring, a furan ring, a benzofuran ring, an isobenzof uran ring, a coumarin ring (for example, 3,4-dihydrocoumarin), a benzimidazole ring, a benzoxazole ring, a rhodanine ring, a pyrazolone ring, an imidazolone ring, a pyran ring, a pyridine ring, a pyrazine ring, a pyrazole ring, a pyrimidine ring, a pyridazine ring, a triazine ring, a fluorene ring, a benzothiophene ring, a benzo(c)thiophene ring, a benzimidazole ring, a benzoxazole ring, a benzisoxazole ring, abenzothiazole ring, an indole ring, aphthalazine ring, a Shinanorin ring, a quinazoline ring, a carbazole ring, a carboline ring, a diazacarboline ring (a ring obtained by substituting any one of the carbon atoms of the carboline with a nitrogen atom), a 1,10-phenanthroline ring, a quinone ring, a rhodanine ring, a dirhodanine ring, a thiohydantoin ring, a pyrazolone ring and a pyrazoline ring. A plurality of these heterocyclic rings may be used in combination, and for example, there is a group derived from phenylpyridine (for example, 4-phenylpyridine), styryl-thiophene

(for example, 2-styryl-thiophene), 2-(9H-fluoren-2-yl)thiophene, 2-phenylbenzo[b]thiophene, a phenylbithiophene ring, (1,1-diphenyl-4-phenyl)-1,3-butadiene, 1,4-diphenyl-1,3-butadiene, 4-(phenylmethylene)-2,5-cyclohexadiene and a phenyldithienothiophene ring.

$Ar_2$ is preferably a group derived from a thiophene ring, a dithienothiophene ring, a cyclopentadithiophene ring and a coumarin ring, more preferably a group derived from a thiophene ring, a dithienothiophene ring, a cyclopentadithiophene ring and a coumarin ring and even more preferably a group derived from a thiophene ring among these.

$Ar_2$ may be a group formed by combining these aromatic ring-containing groups and heterocyclic ring-containing groups, and for example, it may be a group derived from a 2-phenylthiophene ring.

The aromatic ring and the heterocyclic ring of these aromatic ring-containing groups and heterocyclic ring-containing groups may have a substituent, and as the substituent, there are a halogen atom (for example, fluorine, chlorine and bromine), a substituted or unsubstituted linear or branched alkyl group having 1 to 24 carbon atoms (for example, a methyl group, an ethyl group, a propyl group, an isopropyl group, a n-butyl group, a sec-butyl group, a t-butyl group, an isobutyl group, a pentyl group, an isopentyl group, a neopentyl group, a hexyl group, a heptyl group, an octyl group, a nonyl group, a dodecyl group, an octadecyl group and a 3-ethylpentyl group), a hydroxyalkyl group (for example, a hydroxymethyl group and a hydroxyethyl group), an alkoxyalkyl group (for example, methoxyethyl group), an alkoxy group having from 1 to 18 carbon atoms (for example, a methoxy group, an ethoxy group, an ethoxy group, a propoxy group, an isopropoxy group, a butoxy group, a pentyloxy group, a hexyloxy group, a heptyloxy group, an octyloxy group and a nonyloxy group), an aryl group (for example, a phenyl group and a tolyl group), an alkenyl group (for example, a vinyl group and an allyl group), an amino group (for example, a dimethylamino group, a diethylamino group and a diphenylamino group) and a heterocyclic group (for example, a morpholinyl group and a furanyl group).

In addition, in Formula (1), m represents an integer of 0 or more, preferably an integer from 0 to 10, more preferably an integer from 1 to 4, even more preferably an integer from 1 to 3 and even more preferably an integer from 1 to 2.

In other words, $-(Ar_2)_m-$ is preferably a divalent group derived from a benzene ring, a divalent group derived from a thiophene ring and a divalent group formed by combining one or more benzene rings and one or more thiophene rings and more preferably a divalent group derived from a benzene ring and a divalent group formed by combining one benzene ring and one or two thiophene rings.

In Formula (1), $R_2$'s each independently represent a substituted or unsubstituted alkyl group having 1 to 24 carbon atoms, a substituted or unsubstituted cycloalkyl group having from 3 to 24 carbon atoms, a substituted or unsubstituted alkenyl group having 2 to 24 carbon atoms, a substituted or unsubstituted alkynyl group having 2 to 24 carbon atoms, a substituted or unsubstituted hydrocarbon ring-containing group having 6 to 24 carbon atoms or a substituted or unsubstituted heterocyclic ring-containing group, and n is 2 or 3 and preferably 2.

The alkyl group having 1 to 24 carbon atoms, the alkenyl group having 2 to 24 carbon atoms and the alkynyl group having 2 to 24 carbon atoms are as described above.

The cycloalkyl group having from 3 to 24 carbon atoms is not particularly limited, and examples thereof may include a cyclopropyl group, a cyclobutyl group, a cyclopentyl group, a cyclohexyl group, a cycloheptyl group, a cyclooctyl group, a cyclononyl group, a cyclodecyl group, a norbornyl group, an adamantyl group, an isobornyl group, a tricyclodecyl group and a decahydronaphthyl group. Among these, a cycloalkyl group having from 5 to 15 carbon atoms is preferable and a cyclopentyl group, a cyclohexyl group and an adamantyl group are more preferable in consideration of the adsorption properties to the surface of the semiconductor, the adsorptive competitivity with the sensitizing dye, the aggregative adsorption by interaction between the substituents, the inhibition of single layer adsorption, the solubility and the like.

As the hydrocarbon ring-containing group having 6 to 24 carbon atoms, there is a monovalent hydrocarbon ring-containing group. Here, the monovalent hydrocarbon ring-containing group is not particularly limited as long as it is those which are composed of a carbon atom and a hydrogen atom. Specifically, it is those which are derived from a benzene ring, a naphthalene ring and an anthracene ring. A plurality of these aromatic rings may be used in combination, and for example, there is a group derived from a biphenylene group, a terphenylene group, a fluorenylene group, a bithiophene group, a 4-thienylphenylene group, a 2-thienylphenylene group and a diphenylstyryl group, and further, stilbene, 4-phenylmethylene-2,5-cyclohexadiene and triphenylethene (for example, 1,1,2-triphenylethene). These aromatic rings may have a substituent, and as the substituent, there are a halogen atom (for example, fluorine, chlorine and bromine), a substituted or unsubstituted linear or branched alkyl group having 1 to 24 carbon atoms (for example, a methyl group, an ethyl group, a t-butyl group, an isobutyl group, a dodecyl group, an octadecyl group, a 3-ethylpentyl group), a hydroxyalkyl group (for example, a hydroxymethyl group and a hydroxyethyl group), an alkoxyalkyl group (for example, a methoxyethyl group), an alkoxy group having from 1 to 18 carbon atoms (for example, a methoxy group, an ethoxy group, an ethoxy group, a propoxy group, an isopropoxy group, a butoxy group, a pentyloxy group and a hexyloxy group), an aryl group (for example, a phenyl group and a tolyl group), an alkenyl group (for example, a vinyl group and an allyl group), an amino group (for example, a dimethylamino group, a diethylamino group and a diphenylamino group) and a heterocyclic group (for example, a morpholinyl group and a furanyl group).

$R_2$ is preferably a group derived from a benzene ring, styrene and stilbene, more preferably a group derived

from a benzene ring, styrene and stilbene and even more preferably a group (that is, a phenylene group) derived from a benzene ring among these.

Examples of the heterocyclic ring-containing group may include a monovalent group derived from a saturated or unsaturated cyclic compound containing from 1 to 3 hetero atoms selected from a nitrogen atom, an oxygen atom and a sulfur atom. Although it is not limited to the following groups, specific examples thereof may include a morpholinyl group, an oxazolidyl group, a furanyl group, a pyridyl group, a pyrimidinyl group, a furyl group, a pyrrolyl group, a pyrrolidyl group, an imidazolyl group, an imidazolidyl group, a benzimidazolyl group, a pyrazolyl group, a pyrazinyl group, a triazolyl group (for example, a 1,2,4-triazol-1-yl group and a 1,2,3-triazol-1-yl group), an oxazolyl group, a benzoxazolyl group, a thiazolyl group, an isoxazolyl group, an isothiazolyl group, a furazanyl group, a thienyl group, a quinolyl group, a benzofuryl group, a dibenzofuryl group, a benzothienyl group, a dibenzothienyl group, an indolyl group, a carbazolyl group, a carbolinyl group, a diazacarbazolyl group (indicating a group obtained by substituting one of the carbon atoms constituting the carboline ring with a nitrogen atom), a quinoxalinyl group, a pyridazinyl group, a triazinyl group, a quinazolinyl group and a phthalazinyl group.

In addition, n is 2 or 3 and preferably 2.

Meanwhile, the "substituted or unsubstituted" in the above groups means that a group may be substituted with another group or may not be substituted. The substituent which may be substituted is not particularly limited. Specific examples thereof may include a halogen atom (a fluorine atom, a chlorine atom, abromine atom and an iodine atom), a linear or branched alkyl group having 1 to 24 carbon atoms, a cycloalkyl group having 1 to 24 carbon atoms (for example, a cyclopentyl group and a cyclohexyl group), a hydroxyalkyl group having 1 to 24 carbon atoms (for example, a hydroxymethyl group and a hydroxyethyl group), an alkoxyalkyl group having 2 to 24 carbon atoms (for example, a methoxyethyl group), an alkoxy group having 1 to 24 carbon atoms (for example, a methoxy group, an ethoxy group, a propoxy group, an isopropoxy group, a butoxy group, a pentyloxy group, a hexyloxy group, a 2-ethylhexyloxy group, a heptyloxy group, an octyloxy group, a nonyloxy group and a dodecyloxy group), a cycloalkoxy group having from 3 to 24 carbon atoms (for example, a cyclopentyloxy group and a cyclohexyloxy group), an alkenyl group, an alkynyl group, an amino group, an aryl group, an aryloxy group having 6 to 24 carbon atoms (for example, a phenoxy group and a naphthyloxy group), an alkylthio group having 1 to 24 carbon atoms (for example, a methylthio group, an ethylthio group, a propylthio group, a pentylthio group, a hexylthio group, an octylthio group and a dodecylthio group), a cycloalkylthio group having from 3 to 24 carbon atoms (for example, a cyclopentylthio group and a cyclohexylthio group), an arylthio group having 6 to 24 carbon atoms (for example, a phenylthio group and a naphthylthio group), an alkoxycarbonyl group having 1 to 24 carbon atoms (for example, a methyloxycarbonyl group, an ethyloxycarbonyl group, a butyloxycarbonyl group, an octyloxycarbonyl group and a dodecyloxycarbonyl group), an aryloxycarbonyl group having from 7 to 24 carbon atoms (for example, a phenyloxycarbonyl group and a naphthyloxycarbonyl group), a hydroxyl group (-OH), a carboxyl group (-COOH), a thiol group (-SH) and a cyano group (-CN). Meanwhile, the alkyl group, the alkenyl group, the alkynyl group, the amino group and the aryl group are synonymous with those described above and thus the description on them will be omitted here. In addition, the number of the substituents is not particularly limited, and it may be suitably selected in consideration of the desired effect (photoelectric conversion efficiency). In the above, a group is not to be substituted with the same substituent. In other words, the alkyl group to be substituted is not substituted with an alkyl group.

In Formula (1), $Ar_1$ and $Ar_2$ at each end of the carbon-carbon double bond may be in either a cis relation or a trans relation, and the disposition of $Ar_1$ and $Ar_2$ is determined by the steric repulsion and the like.

In Formula (1) above, $-(Ar_2)_m-$ is preferably represented by the following Formula.

[Chem. 4]

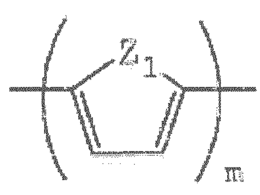

In other words, the sensitizing dye of Formula (1) above is preferably represented by the following Formula (2).

[Chem. 5]

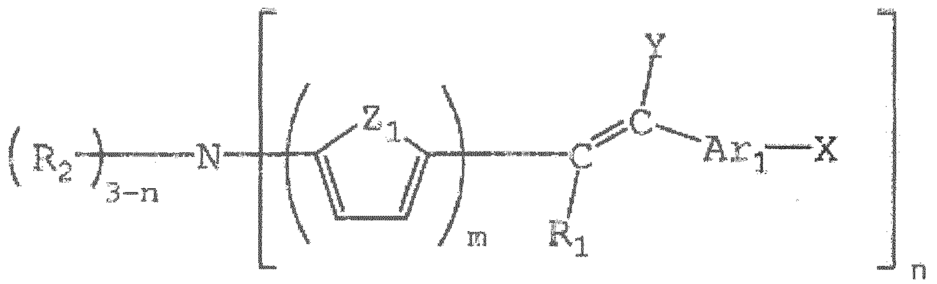

(2)

In Formula (2) above, $Ar_1$, $R_1$, $R_2$, X, Y, m and n are synonymous with those in Formula (1) described above and thus the description on them will be omitted here.

In Formula (2), $Z_1$'s each independently represent S or C=C. In other words, $Z_1$'s each independently represent a thiophene ring or a benzene ring. Specifically, the moiety represented by the following Formula:

[Chem. 6]

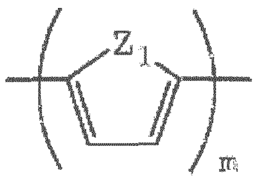

is preferably a group represented by the following Formulae:

[Chem. 7]

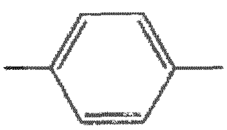

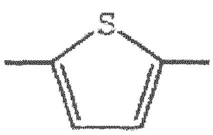

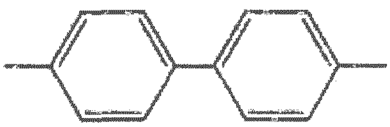

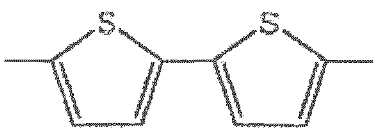

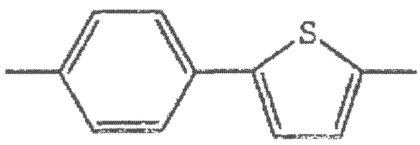

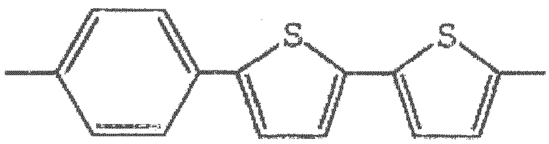

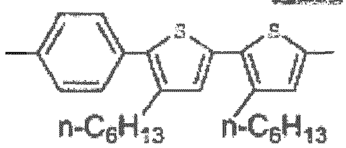

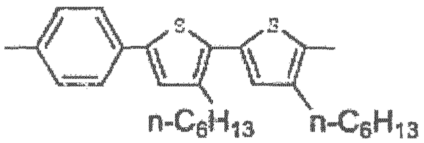

In addition, in Formula (2), $R_1$ and Y at each end of the carbon-carbon double bond may be in either a cis relation or a trans relation.

In addition, Formula (1) above is preferably represented by the following Formula (3).

[Chem. 8]

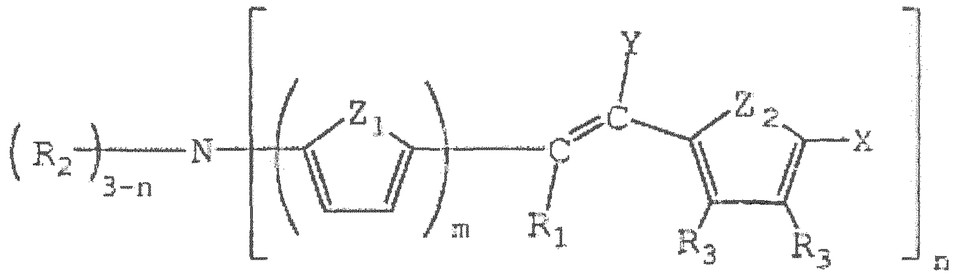

(3)

In Formula (3) above, $R_1$, $R_2$, X, Y, m and n are synonymous with those in Formula (1) described above and thus the description on them will be omitted here.

In Formula (3), $Z_1$'s and $Z_2$'s each independently represent S or C=C.

In Formula (3), $R_3$'s each independently represent a hydrogen atom, a substituted or unsubstituted alkyl group having 1 to 24 carbon atoms, a substituted or unsubstituted alkenyl group having 2 to 24 carbon atoms, a substituted or unsubstituted alkynyl group having 2 to 24 carbon atoms, a substituted or unsubstituted alkoxy group having 1 to 24 carbon atoms, a substituted or unsubstituted aryl group having 6 to 24 carbon atoms or a substituted or unsubstituted heterocyclic group, and two $R_3$'s may be joined to each other to form a ring.

The alkyl group having 1 to 24 carbon atoms, the alkenyl group having 2 to 24 carbon atoms, the alkynyl group having 2 to 24 carbon atoms, the alkoxy group having 1 to 24 carbon atoms, the aryl group having 6 to 24 carbon atoms and the heterocyclic group are synonymous with the groups described above, and the description on them will be omitted here.

Here, the alkoxy group having 1 to 24 carbon atoms may be either linear or branched and it is not particularly limited, but examples thereof may include a methoxy group, an ethoxy group, a n-propoxy group, an isopropoxy group, a n-butoxy group, an isobutoxy group, a sec-butoxy group, a tert-butoxy group, a n-pentyloxy group, an isopentyloxy group, a tert-pentyloxy group, a neopentyloxy group, a 1,2-dimethylpropoxy group, a n-hexyloxy group, an iso-hexyloxy group, a 1,3-dimethylbutoxy group, a 1-isopropylpropoxy group, a 1,2-dimethylbutoxy group, a n-heptyloxy group, a 1, 4 -dimethylpentyloxy group, a 3 -ethylpentyloxy group, a 2-methyl-1-isopropylpropoxy group, a 1-ethyl-3-methylbutoxy group, a n-octyloxy group, a 2-ethylhexyloxy group, a 3-methyl-1-isopropylbutoxy group, a 2-methyl-1-isopropoxy group, a 1-t-butyl-2-methylpropoxy group, a n-nonyloxy group, a 3,5,5-trimethylhexyloxy group, a n-decyloxy group, an iso-decyloxy group, a n-undecyloxy group, a 1-methyldecyloxy group, a n-dodecyloxy group, a n-tridecyloxy group, a n-tetradecyloxy group, a n-pentadecyloxy group, a n-hexadecyloxy group, a n-heptadecyloxy group, a n-octadecyloxy group, a n-nonadecyloxy group, a n-eicosyloxy group, a n-heneicosyloxy group, a n-docosyloxy group, a n-tricosyloxy group and a n-tetracosyloxy group. Among these, a linear or branched alkyl group having from 1 to 8 carbon atoms is preferable and a methoxy group, an ethoxy group, a n-hexyloxy group and a n-octadecyloxy group are more preferable.

In addition, in Formula (3), two $R_3$'s may be joined to each other to form a ring, and specifically, the moiety represented by the following Formula:

[Chem. 9]

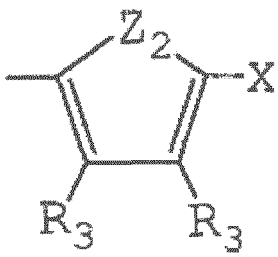

is preferably a group represented by the following Formula:

[Chem. 10]

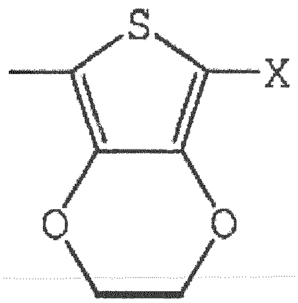

In Formula (3), $R_1$ and Y at each end of the carbon-carbon double bond may be in either a cis relation or a trans relation.

In addition, preferred examples of the sensitizing dye according to the invention are presented below. Meanwhile, the invention is not intended to be limited thereto. Meanwhile, the sensitizing dye is defined by the following compound number in Examples to be described below.

[Chem. 11]

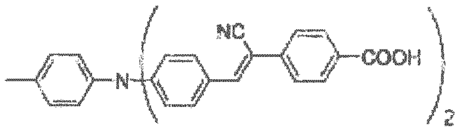
Compound 1

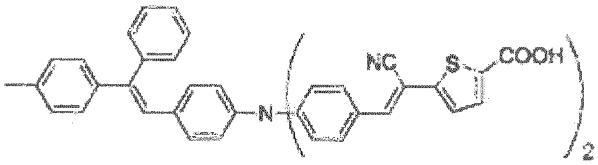
Compound 2

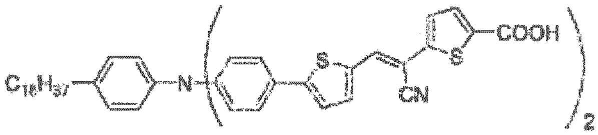
Compound 3

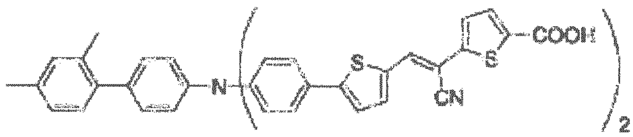
Compound 4

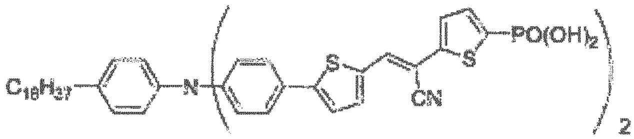
Compound 5

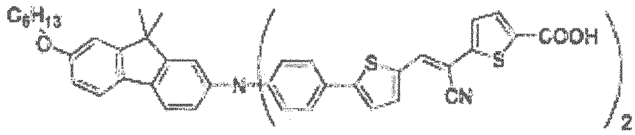
Compound 6

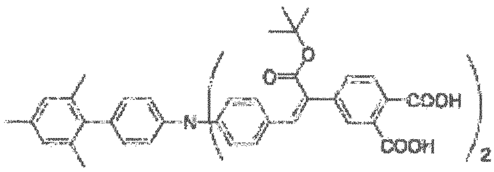
Compound 7

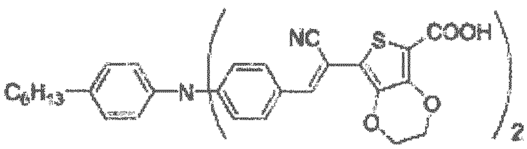
Compound 8

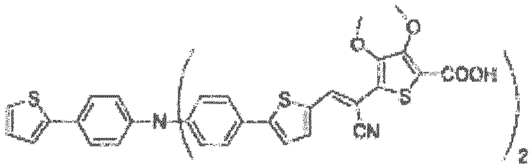
Compound 9

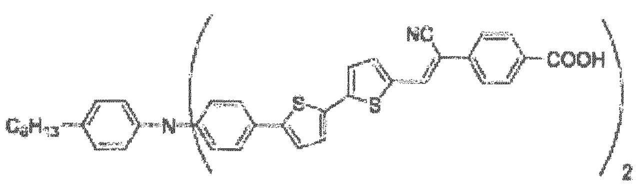
Compound

[Chem. 12]

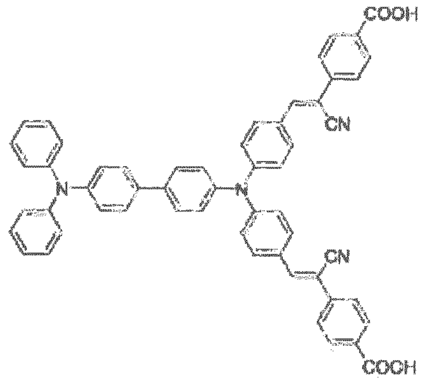
Compound

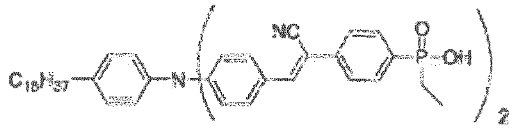
Compound

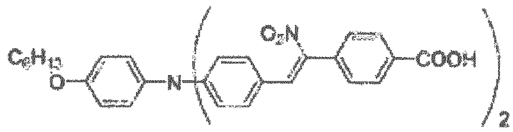
Compound

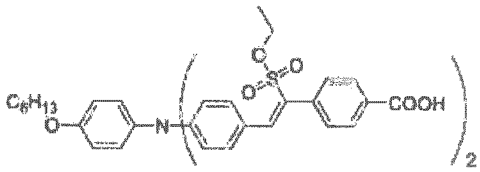
Compound

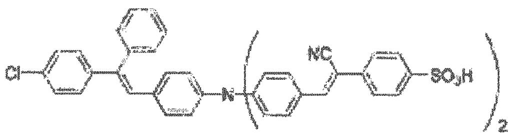
Compound

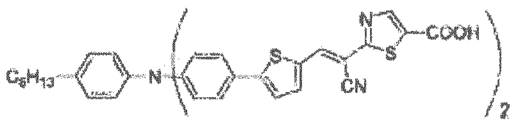
Compound

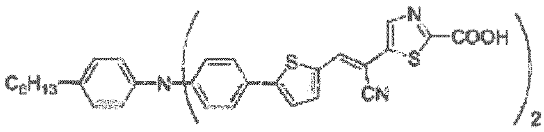
Compound

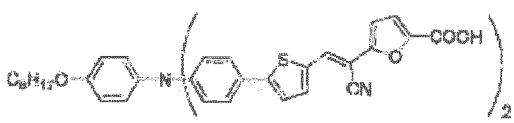
Compound

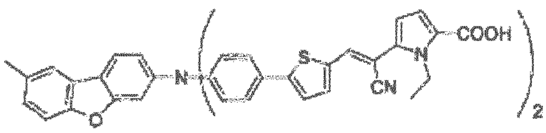
Compound

[Chem. 13]

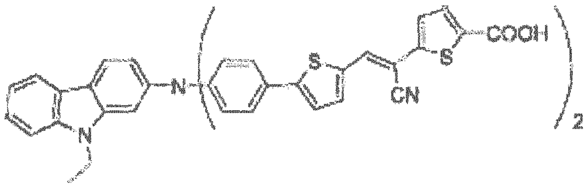
Compound

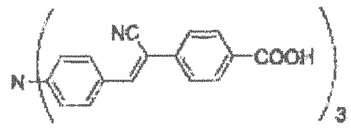
Compound

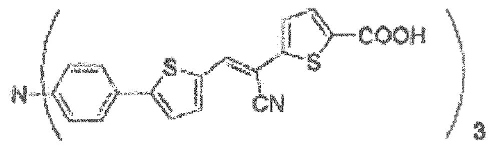
Compound

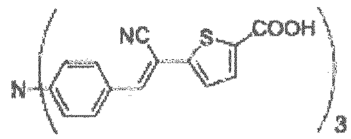
Compound

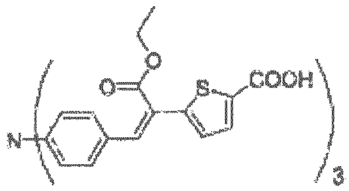
Compound

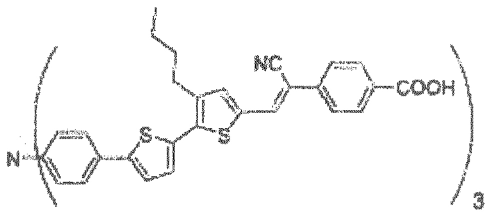
Compound

All of the above compounds can be synthesized by those skilled in the art by appropriately combining a reaction known in the art, for example, an electrophilic aromatic substitution reaction, a nucleophilic aromatic substitution reaction, a coupling reaction and a metathesis reaction. Incidentally, upon the synthesis of the above compounds, it is possible to make reference to JP 7-5706 A and JP 7-5709 A.

In addition, it is also possible to concurrently use the sensitizing dye according to the invention and another sensitizing dye. As the sensitizing dye which can be concurrently used, any sensitizing dye can be used as long as it is capable of spectrally sensitizing the semiconductor layer according to the invention. It is also preferable to mix two or more kinds of sensitizing dyes in order to widen the wavelength region of photoelectric conversion as possible and to increase the photoelectric conversion efficiency. In addition, it is possible to choose the sensitizing dye to be mixed and the proportion thereof so as to be matched to the intended wavelength region and intensity distribution of the light source.

It is also preferable to use two or more kinds of sensitizing dyes having different absorption wavelengths as a mixture so as to be able to widen the wavelength region of photoelectric conversion as possible and to effectively utilize sunlight particularly in a case in which the application of the photoelectric conversion element of the invention is a solar cell to be described below.

Among the sensitizing dyes to be concurrently used, a metal complex dye, a phthalocyanine-based dye, a porphyrin-based dye and a polymethine-based dye are preferably used as another sensitizing dye from overall viewpoint of light electron transfer reaction activity, light durability, photochemical stability and the like. Alternatively, it is possible to mention, for example, the sensitizing dyes described in US 4,684,537, US 4,927,721, US 5,084,365, US 5,350,644,

US 5,463,057, US 5,525,440, JP 7-249790 A, JP 2000-150007 A and the like and a sensitizing dye having a carboxyl group. Meanwhile, it is preferable to use a sensitizing dye having a phosphoric acid group as another sensitizing dye in consideration of the elution of the dye from the basic solution.

(Method for fabricating photoelectric conversion layer)

Next, a method for fabricating a photoelectric conversion layer will be described. The method for fabricating a photoelectric conversion layer is divided into (1) the formation of a semiconductor layer on a conductive support and (2) the sensitization treatment of the semiconductor. In (1), in a case in which the material of the semiconductor is a particulate, the semiconductor layer can be formed by a method in which a dispersed liquid or colloidal solution (semiconductor-containing coating liquid) of the semiconductor is coated or sprayed on a conductive support and a method (sol-gel method) in which a precursor of the semiconductor fine particles is coated on a conductive support, hydrolyzed by the moisture (for example, moisture in the air), and then subjected to the condensation. It is preferable that the semiconductor layer obtained by the above two methods be calcined. In this case, it is preferable to quickly conduct the sensitization treatment by a sensitizing dye before the moisture adsorbs on the semiconductor after calcination. In addition, in (1), in a case in which the material of the semiconductor has a membrane shape and is not held on a conductive support, the semiconductor layer can be formed by pasting the semiconductor on the conductive support. As the sensitization treatment method of (2), the adsorption of the sensitizing dye on the semiconductor layer may be mentioned.

Hereinafter, a method for fabricating a photoelectric conversion layer to be preferably used in the invention will be described in detail.

(1) Formation of semiconductor layer on conductive support

(1-1) Preparation of semiconductor-containing coating liquid

First, a coating liquid containing a semiconductor, preferably a fine powder of semiconductor (semiconductor-containing coating liquid) is prepared. The primary particle size of the semiconductor fine powder is preferably to be fine. The primary particle size is preferably from 1 to 5000 nm and more preferably from 2 to 500 nm. The semiconductor-containing coating liquid can be prepared by dispersing the semiconductor fine powder in a solvent, and the semiconductor fine powder dispersed in the solvent is dispersed in the shape of primary particles. The concentration of the semiconductor fine powder in the solvent is preferably from 0.1 to 70% by mass and more preferably from 0.1 to 30% by mass.

The solvent usable in the semiconductor-containing coating liquid is not particularly limited as long as a solvent can disperse the semiconductor fine powder, and water, an organic solvent, a mixture of water and an organic solvent can be used. Specific examples of the organic solvent may include an alcohol such as methanol, ethanol, isopropyl alcohol and tert-butyl alcohol; a ketone such as methyl ethyl ketone, acetone and acetylacetone; a hydrocarbon such as hexane and cyclohexane; a nitrile-based solvent such as acetonitrile and benzonitrile; and a cellulose derivative such as acetylcellulose, nitrocellulose, acetylbutylcellulose, ethylcellulose and methylcellulose. A surface active agent, an acid (acetic acid, nitric acid and the like), a viscosity modifier (a polyhydric alcohol such as polyethylene glycol, and the like), a chelating agent (acetylacetone and the like) may be added to the coating liquid, if necessary. Meanwhile, one kind of these organic solvents may be used singly or two or more kinds thereof may be used as a mixture.

(1-2) Coating of semiconductor-containing coating liquid

The semiconductor-containing coating liquid prepared by (1-1) above is coated or sprayed on a conductive support, dried and the like, thereby forming a semiconductor layer. The coating method is not particularly limited, and it is possible to conduct coating by a method known in the art such as a doctor blade method, a squeegee method, a spin coating method and a screen printing method. The semiconductor layer obtained by coating or spraying and drying is composed of an aggregate of the semiconductor fine particles and the particle size of the fine particles corresponds to the primary particle size of the semiconductor fine powder used. Meanwhile, the semiconductor-containing coating liquid may be a coating liquid containing two or more kinds of semiconductor materials, and it is possible to conduct coating or spraying using two or more kinds of semiconductor materials so as to form a semiconductor layer having a layered structure.

(1-3) Calcination treatment of semiconductor layer

The semiconductor layer formed by (1-2) above is preferably calcined in the air or an inert gas. By conducting the calcination, it is possible to enhance the bonding strength between the semiconductor layer formed in (1-2) and the

conductive support and the bonding strength between the semiconductor fine particles and thus to improve the mechanical strength. The conditions for calcination are not particularly limited as long as a semiconductor layer having a desired actual surface area and porosity can be formed. The temperature for calcination is not particularly limited, but it is preferably 1000°C or lower, more preferably from 100 to 800°C and even more preferably from 200 to 600°C. In addition, the semiconductor fine particles and the substrate and the semiconductor fine particles may be pressurized to be fixed to each other or only the semiconductor layer may be calcined using a microwave in a case in which the substrate is a plastic or the like to be inferior in heat resistance. The time for calcination is also not particularly limited, but it is preferably from 10 seconds to 12 hours, more preferably 1 to 240 minutes and even more preferably from 10 to 120 minutes. The atmosphere for calcination is also not particularly limited, but the calcination step is usually carried out in the air or an inert gas (for example, argon, helium, nitrogen and the like) atmosphere. Meanwhile, the calcination may be conducted only one time at a single temperature or may be repeated two or more times while changing the temperature and the time.

The structure of the semiconductor layer calcined is not particularly limited, but it is preferably a porous structure (porous structure with voids) from the viewpoint of effectively conducting the adsorption of the sensitizing dye. Hence, the porosity (D) of the semiconductor layer is preferably from 1 to 90% by volume, even more preferably from 10 to 80% by volume and even more preferably from 20 to 70% by volume. Meanwhile, the porosity of the semiconductor layer means the porosity that penetrate in the thickness direction of the dielectric and it can be measured using a commercially available apparatus such as a mercury porosimeter (Shimadzu Pore Sizer, model 9220). Meanwhile, in a case in which the semiconductor layer is a porous structure film, it is preferable to manufacture a photoelectric conversion element so that the material constituting the charge transport layer is present in the voids as well.

The film thickness of the semiconductor layer calcined is not particularly limited, but it is preferably 10 nm or more and even more preferably from 500 nm to 30 μm.

The ratio of the actual surface area to the apparent surface area of the semiconductor layer obtained can be controlled by the particle size and specific surface area of the semiconductor fine particles, the temperature for calcination and the like. In addition, the semiconductor layer obtained may be subjected, for example, to chemical plating treatment using an aqueous solution of titanium tetrachloride or electrochemical plating treatment using an aqueous solution of titanium trichloride after calcination so as to control the surface area of the semiconductor particles and the purity in the vicinity of the semiconductor particles and to enhance the electron injection efficiency from the dye to the semiconductor particles.

(2) Sensitization treatment of semiconductor by sensitizing dye

The sensitization treatment of the semiconductor by the sensitizing dye is conducted, for example, by dissolving the sensitizing dye in a suitable solvent and immersing the semiconductor layer which is carefully dried in the solution for a long time. The sensitizing dye can be adsorbed on the semiconductor by this sensitization treatment. At this time, it is preferable to remove the air bubbles in the film and the moisture in the voids by conducting a pretreatment such as decompression treatment and heat treatment prior to immersion in a case in which the semiconductor layer has a porous structure. The sensitizing dye can be adsorbed even on the inside of the semiconductor layer by this pretreatment. Meanwhile, the sensitization treatment is not limited to the immersion of the semiconductor layer in the sensitizing dye-containing solution, and another method for sensitization treatment known in the art can also be appropriately applied.

The conditions for sensitization treatment are not particularly limited, but it is preferable to set to the conditions so that the sensitizing dye can deeply penetrate into the semiconductor layer and the adsorption and the like can sufficiently proceed. For example, the temperature for the sensitization treatment is preferably from 5 to 100°C and more preferably from 25 to 80°C from the viewpoint of preventing the decomposition of the sensitizing dye and the adsorption of the decomposition product on the semiconductor layer in the solution. In addition, the time for the sensitization treatment is preferably from 15 minutes to 20 hours and more preferably from 3 to 24 hours. In particular, it is preferable to conduct the sensitization treatment at room temperature (25°C) for from 2 to 48 hours, especially from 3 to 24 hours, but the time for sensitization treatment may be appropriately changed depending on the temperature to be set. In addition, the sensitization treatment may be conducted under reduced pressure or in a vacuum from the viewpoint of shortening the time for sensitization treatment and adsorbing the sensitizing dye even on the deep part of the semiconductor layer.

There is no particular limitation on the solvent used to dissolve the sensitizing dye as long as a solvent can dissolve the sensitizing dye and does not dissolve the semiconductor or does not react with the semiconductor. However, it is preferable that the solvent be previously degassed and purified by distillation in order to prevent the sensitization treatment such as the adsorption of the sensitizing dye from being inhibited by the penetration of the moisture and gas dissolved in the solvent into the semiconductor film. Examples of the solvent which is preferably used in the dissolution of the sensitizing dye may include a nitrile-based solvent such as acetonitrile; an alcohol-based solvent such as methanol, ethanol, n-propanol, isopropyl alcohol and tert-butyl alcohol; a ketone-based solvent such as acetone and methyl ethyl ketone; an ether-based solvent such as diethyl ether, diisopropyl ether, tetrahydrofuran and 1,4-dioxane; and a halogenated hydrocarbon solvent such as methylene chloride and 1,1,2-trichloroethane. These solvents may be used singly

or as a mixture of two or more kinds. Among these, it is preferable to use acetonitrile, methanol, ethanol, n-propanol, isopropyl alcohol, tert-butyl alcohol, acetone, methyl ethyl ketone, tetrahydrofuran and methylene chloride, and a mixed solvent of these, for example, an acetonitrile/methanol mixed solvent, an acetonitrile/ethanol mixed solvent and an acetonitrile/tert-butyl alcohol mixed solvent.

The sensitizing dye may be used singly or a plurality of sensitizing dyes may be concurrently used in the case of conducting the sensitization treatment. In addition, the sensitizing dye may be used as a mixture with another sensitizing dye (for example, the compounds described in US 4, 684, 537, US 4, 927, 721, US 5, 084, 365, US 5, 350, 644, US 5,463,057, US 5,525,440, JP 7-249790 A and JP 2000-150007 A), but it is preferable to use only the sensitizing dye according to the invention from the viewpoint of the photoelectric conversion efficiency. It is preferable to use two or more kinds of sensitizing dyes having different absorption wavelengths as a mixture so as to be able to widen the wavelength region of photoelectric conversion as possible and to effectively utilize sunlight in a case in which the application of the photoelectric conversion element of the invention is a solar cell to be described below. The method for sensitization treatment in the case of using two or more kinds of sensitizing dyes is not particularly limited, and the semiconductor layer may be immersed in a mixed solution of the respective sensitizing dyes or a solution of each sensitizing dye is separately prepared and the semiconductor layer is sequentially immersed therein.

In the photoelectric conversion layer obtained, the total supported amount of the sensitizing dye per 1 $m^2$ of the semiconductor layer is not particularly limited, but it is preferably from 0.01 to 100 mmol, even more preferably from 0.1 to 50 mmol and even more preferably from 0.1 to 20 mmol.

[Charge transport layer]

The charge transport layer used in the invention will be described.

The charge transport layer is a layer having a function to quickly reduce the oxidized dye and to transport the holes injected at the interface with the dye to a counter electrode.

The charge transport layer according to the invention is configured to contain a dispersed substance of a redox electrolyte or a p-type compound semiconductor (charge transport agent) as a hole transport material as a main component.

Examples of the redox electrolyte may include an $I^-/I_3^-$ based electrolyte, a $Br^-/Br_3^-$ based electrolyte and a quinone/hydroquinone-based electrolyte. Such a redox electrolyte can be obtained by a method known in the related art, and for example, the $I^-/I_3^-$ based electrolyte can be obtained by mixing an ammonium salt of iodine and iodine. These dispersed substances are called a liquid electrolyte in the case of a solution, a solid macromolecular electrolyte in the case of being dispersed in a macromolecule which is solid at room temperature, and a gel electrolyte in the case of being dispersed in a gel-like substance. In the case of using a liquid electrolyte as the charge transport layer, those which are electrochemically inert are used as a solvent thereof and, for example, acetonitrile, valeronitrile, propylene carbonate and ethylene carbonate are used. Examples of the solid macromolecular electrolyte may include the electrolytes described in JP 2001-160427 A and examples of the gel electrolyte may include the electrolytes described in the "Journal of the Surface Science Society of Japan" Vol. 21, No. 5, pp 288-293.

As the charge transport agent, it is preferable to have a large band gap in order not to interfere with the dye absorption. The band gap of the charge transport agent used in the invention is preferably 2 eV or more and further it is preferably 2.5 eV or more. In addition, the ionization potential of the charge transport agent is required to be less than the ionization potential of the dye adsorbed electrode in order to reduce the dye holes. The preferred range of the ionization potential of the charge transport agent used in the charge transport layer varies depending on the dye used, but it is generally preferably 4.5 eV or more and 5.5 eV or less and further it is preferably 4.7 eV or more and 5.3 eV or less.

As the charge transport agent, an aromatic amine derivative excellent in the hole transport capability and a conductive macromolecule are preferable. Hence, it is possible to further improve the photoelectric conversion efficiency as the charge transport layer is mainly composed of an aromatic amine derivative and a conductive macromolecule. In particular, it is preferable to use a triphenyldiamine derivative as the aromatic amine derivative. The triphenyldiamine derivative is particularly excellent in the hole transport capability among the aromatic amine derivatives. In addition, as such an aromatic amine derivative, any of a monomer, an oligomer, a prepolymer and a polymer may be used or these may be used as a mixture. In addition, a monomer, an oligomer or a prepolymer has a relatively low molecular weight and thus the solubility in a solvent such as an organic solvent is high. Hence, there is an advantage that the preparation of the charge transport layer material can be more easily performed in the case of forming the charge transport layer by a coating method. Among these, it is preferable to use a dimer or a trimer as the oligomer.

Specific examples of an aromatic tertiary amine compound may include N,N,N',N'-tetraphenyl-4,4'-diaminophenyl; N,N'-diphenyl-N,N'-bis(3-methylphenyl)-[1,1'-biphen yl]-4,4'-diamine (TPD); 2,2-bis(4-di-p-tolylaminophenyl)propane; 1,1-bis(4-di-p-tolylaminophenyl)cyclohexane; N,N,N',N'-tetra-p-tolyl-4,4'-diaminobiphenyl; 1,1-bis(4-di-p-tolylaminophenyl)-4-phenylcyclohexan e; bis(4-dimethylamino-2-methylphenyl)phenylmethane; bis(4-di-p-tolylaminophenyl)phenylmethane; N,N'-diphenyl-N,N'-di(4-methoxyphenyl)-4,4'-diamino biphenyl;N,N,N',N'-tetraphenyl-4,4'-diaminodiphenyl ether; 4,4'-bis(diphenylamino)quardriphenyl; N,N,N-tri(p-tolyl)amine; 4-(di-p-tolylamino)-4'-[4-(di -p-tolylamino)styryl]stilbene; 4-N,N-diphenylamino-(2-diphenylvinyl)benzene; 3-methoxy-4'-N,N-diphenylaminostilbenzene; N-phenylcarbazole, further, those which are described in US 5,061,569 and have two condensed aromatic rings in the molecule, for example, 4,4'-bis[N-(1-naphthyl)-N-phenylamino]biphenyl(NPD), and 4,4',4"-tris[N-(3-methylphenyl)-N-phenylamino]triph enylamine (MTDATA) in which three triphenylamine units are linked to one another in a star-burst type described in JP 4-308688 A. Furthermore, it is also possible to use a macromolecula material in which these materials are introduced into the macromolecular chain or these materials are contained as the main chain of the macromolecule.

The conductive macromolecule contains a compound represented by the following Formula (10) or a polymerized substance (hereinafter, simply referred to as the "polymer" as well) formed by polymerizing a multimer of the compound.

[Chem. 14]

Formula (10)

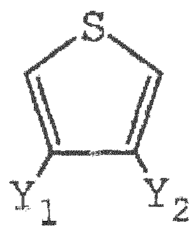

In Formula (10) above,
$Y^1$ and $Y^2$ represent a hydrogen atom, a linear or branched alkyl group having 1 to 24 carbon atoms, an aryl group having 6 to 24 carbon atoms, a $-OR^4$ group, a $-SR^5$ group, a $-SeR^6$ group or a $-TeR^7$ group. Meanwhile, $Y^1$ and $Y^2$ may be the same as or different from each other. $R^4$ to $R^7$ represent a hydrogen atom or a linear or branched alkyl group having 1 to 24 carbon atoms. Here, $Y^1$ and $Y^2$ may be bonded to each other to form a ring structure.

The linear or branched alkyl group having 1 to 24 carbon atoms as $Y^1$, $Y^2$ and $R^4$ to $R^7$ above is not particularly limited, and it is the same as the alkyl group in Formula (1) above.

Among these, a linear or branched alkyl group having from 6 to 18 carbon atoms is preferable and a linear alkyl group having from 6 to 18 carbon atoms is more preferable as $Y^1$ and $Y^2$. In a case in which the polymer has a long chain alkyl group (for example, having from 6 to 18 carbon atoms), it is presumed that the alkyl group acts as a functional group which inhibits the self-aggregation, thus the formation of a self-aggregated structure is suppressed, and the durability is improved as a result.

In addition, as $R^4$ to $R^7$, a linear or branched alkyl group having from 1 to 5 carbon atoms is preferable and a linear alkyl group having from 1 to 5 carbon atoms is preferable.

The aryl group having 6 to 24 carbon atoms as $Y^1$ and $Y^2$ is not particularly limited, and it is the same as the aryl group in Formula (1) above.

In $Y^1$, $Y^2$ and $R^4$ to $R^7$, at least one of the hydrogen atoms in the "linear or branched alkyl group having 1 to 24 carbon atoms" and the "aryl group having 6 to 24 carbon atoms" may be substituted with a substituent.

In $Y^1$, $Y^2$ and $R^4$ to $R^7$, the substituent is selected from the group consisting of a halogen atom, a substituted or unsubstituted linear or branched alkyl group having 1 to 24 carbon atoms, a hydroxyalkyl group having from 1 to 18 carbon atoms, an alkoxy group having from 1 to 18 carbon atoms, an acyl group having from 1 to 32 carbon atoms, an aryl group having 6 to 24 carbon atoms, an alkenyl group having from 2 to 32 carbon atoms, an amino group, and a heteroaryl group having 2 to 24 carbon atoms. These specific groups are the same as the groups in Formula (1) above.

The substituent of $Y^1$, $Y^2$ and $R^4$ to $R^7$ is preferably a linear alkyl group having from 6 to 18 carbon atoms and more preferably a n-octyl group.

Preferred examples of the compound represented Formula (10) above may include the following compounds (H1-1) to (H1-7). In addition, in the invention, a compound having the following compounds (H1-1) to (H1-7) as a partial structure is preferably used as the conductive macromolecule. However, the invention is not limited thereto. In addition, the polymer constituting the conductive macromolecule is defined by the following symbols in Examples to be described below.

[Chem. 15]

H1−1

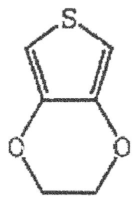

H1−2

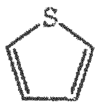

H1−3

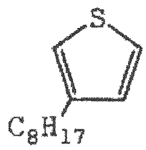

H1−4

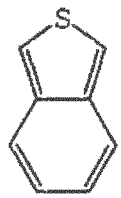

H1−5

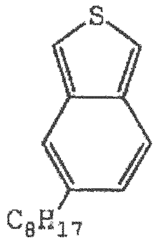

H1−6

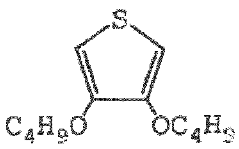

H1−7

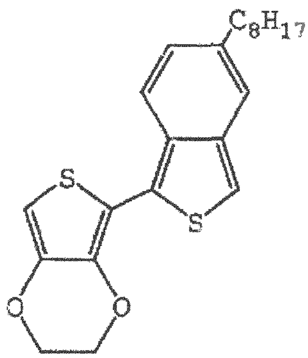

The end of the above polymer is not particularly limited, and it is appropriately defined by the kind of the raw material (a monomer, a dimer, a multimer and the like) used, but it is usually a hydrogen atom. Here, the polymer used in the invention may be formed from only the compound represented by Formula (10) above or may be formed from the compound represented by Formula (10) above and another monomer. Preferably, it is formed from only the compound represented by Formula (10) above. In addition, at that time, the polymer may be formed from only a single species of the compound represented by Formula (10) above or may be formed from plural species of the compounds represented by Formula (10) above.

In addition, another monomer is not particularly limited as long as a monomer does not inhibit the properties of the polymer according to the invention, and a monomer known in the art can be used. Specific examples thereof may include a monomer such as a pyrrole derivative, a furan derivative or a thiadiazole or a monomer having a $\pi$-conjugated structure.

The polymer used in the invention can be obtained by a method in which one kind or two or more kinds of compounds represented by Formula (10) above or a mul timer of these compounds is polymerized or copolymerized together with another monomer if necessary in the presence of a metal complex as a polymerization catalyst.

Here, it is possible to use the compound (monomer) exemplified above as the compound represented by Formula (10) above. In addition to the above, it is possible to use those which are obtained by the multimerization of a dimer or a trimer of the compound represented by Formula (10) above (oligomerized compound; hereinafter, also referred to as the "multimer" collectively) in the above polymerization or copolymerization.

For example, dimers (H2-1) to (H2-7) of the compounds (H1-1) to (H1-7) can be preferably used.

[Chem. 16]

H2-1

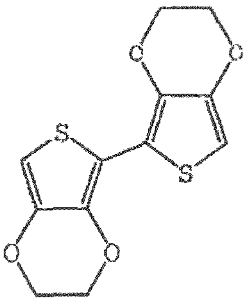

H2-2

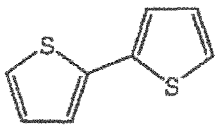

H2-3

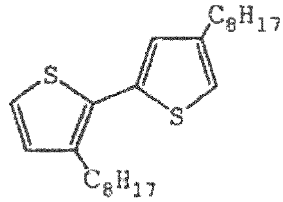

H2-4

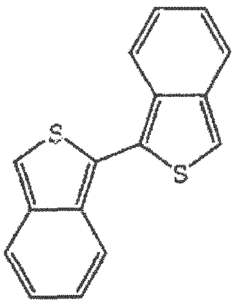

H2-5

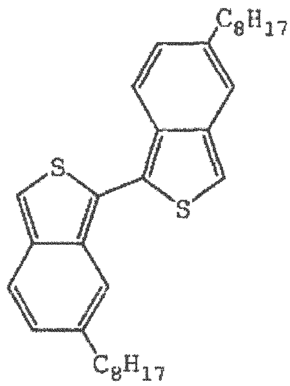

H2-6

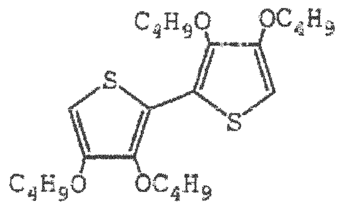

H2-7

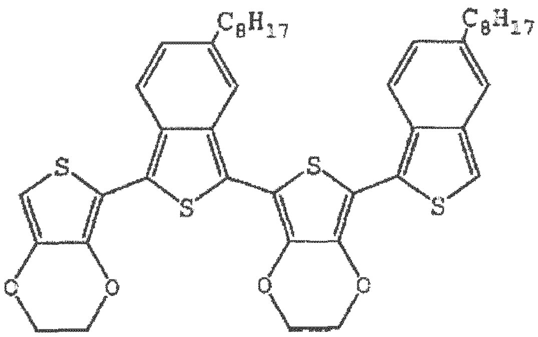

It is preferable to use a multimer such as a dimer as described above since the oxidation potential at the time of forming the polymer decreases as compared to the case of using a monomer and thus the synthetic rate of the polymer increases. The oligomerized compounds of these monomers can be synthesized, for example, by the method described in J. R. Reynolds et. al., Adv. Mater., 11, 1379 (1999) or an appropriately modified method thereof. In addition, a dimer of the monomer can be synthesized by the method described in T. M. Swager et. al. , Journal of the American Chemical Society, 119, 12568 (1997) or an appropriately modified method thereof.

A preferred example of the production method of a 3,4-ethylenedioxythiophene (PEDOT) dimer (H2-1) that is the dimer of the monomer (H1-1) of the above polymer is described below, for example. However, the invention is not intended to be limited to the following preferred example, and another similar method or another method known in the art can be applied.

[Synthesis of 3,4-ethylenedioxythiophene (PEDOT) dimer]

To a 1000 mL glass three-necked flask equipped with a stirrer, a thermometer and a reflux condenser, 750 mL of anhydrous tetrahydrofuran and 25 g (0.15 mol) of 3,4-ethylenedioxythiophene are added and cooled until the internal temperature reaches - 70°C in an acetone/dry ice bath under a nitrogen stream while stirring. Thereafter, 113 mL (0.18 mol) of a n-butylli thium hexane solution at 1.6 mol/L is added dropwise to the reaction system over 5 minutes using a

syringe. After 25 minutes, 23.5 g (0.17 mol) of anhydrous copper chloride is added thereto and allowed to react as it is for approximately 3 hours while stirring. The reaction mixture is added to 10 L of water, the product is filtered, then dried, and purified by silica gel chromatography (mobile phase : methylene chloride), thereby obtaining 17.9 g (yield: 72%) of the PEDOT dimer as a yellowish white crystal.

(Polymerization method of polymer)

The polymerization method is not particularly limited, and a polymerization method known in the art, for example, the method described in JP 2000-106223 A can be applied.

Specific examples thereof may include a chemical polymerization method using a polymerization catalyst, an electrolytic polymerization method in which the reaction proceeds as a voltage is applied between the electrodes equipped with at least a working electrode and a counter electrode, and a photopolymerization method combining the light irradiation singly or a polymerization catalyst, heating, electrolysis and the like. Among these, the polymerization method using the electrolytic polymerization method is preferable and the electrolytic polymerization method and the photopolymerization method combining the light irradiation are more preferable. It is possible to densely form a layer of the polymer on the surface of titanium oxide by using the electrolytic polymerization method and the photopolymerization method to polymerize by the irradiation of light in combination.

In the case of obtaining the polymer by the electrolytic polymerization method, the synthesis of the polymer leads to the formation of the charge transport layer as it is. In other words, the electrolytic polymerization method as to be described below is carried out. In general, a mixture containing a monomer constituting the polymer, a supporting electrolyte, a solvent and additives if necessary is used.

The monomer represented by Formula (10) above or a multimer of the monomer and another monomer if necessary are dissolved in a proper solvent and a supporting electrolyte is added thereto, thereby preparing a solution for electrolytic polymerization.

Here, the solvent is not particularly limited as long as a solvent can dissolve the supporting electrolyte and the monomer or a multimer thereof, but it is preferable to use an organic solvent having a relatively wide potential window. Specific examples thereof may include a polar solvent such as tetrahydrofuran (THF), butylene oxide, chloroform, cyclohexanone, chlorobenzene, acetone and various kinds of alcohols, and an organic solvent such as an aprotic solvent including dimethylformamide (DMF), acetonitrile, dimethoxyethane, dimethylsulfoxide, hexamethylphosphoric triamide, propylene carbonate, dichloromethane, o-dichlorobenzene and methylene chloride. Alternatively, the above solvents may be used as a mixed solvent obtained by adding water or another organic solvent thereto if necessary. In addition, the above solvents may be used singly or in the form of a mixture of two or more kinds.

As the supporting electrolyte, those which are able to ionize is used, although it is not limited to a specific one, but those which are highly soluble in a solvent and hardly oxidized or reduced are preferably used. Specific examples thereof may preferably include a salt such as lithium perchlorate ($LiClO_4$), lithium tetrafluoroborate, tetrabutylammonium perchlorate, $Li[(CF_3SO_2)2N]$, $(n\text{-}C_4H_9)_4NBF_4$, $(n\text{-}C_4H_9)_4NPF_4$, and a p-toluenesulfonate salt and a dodecylbenzenesulfonate salt. Alternatively, the polymer electrolytes described in JP 2000-106223 A (for example, PA-1 to PA-10 in the publication) may be used as a supporting electrolyte, and the supporting electrolytes may be used singly or in the form of a mixture of two or more kinds.

Examples of the additive that can be added to the charge transport layer may include various kinds of additives such as a coatable modifier including an acceptor doping agent such as $N(PhBr)_3SbCl_6$, $NOPF_6$, $SbCl_5$, $I_2$, $Br_2$, $HClO_4$, $(n\text{-}C_4H_9)_4ClO_4$, trifluoroacetic acid, 4-dodecylbenzenesulfonic acid, 1-naphthalenesulfonic acid, $FeCl_3$, $AuCl_3$, $NOSbF_6$, $AsF_5$, $NOBF_4$, $LiBF_4$H1-3 $[PMo_{12}O_{40}]$ and 7,7,8,8-tetracyanoquinodimethane (TCNQ), a binder resin which hardly traps a hole and a leveling agent. The above additives may be used singly or in the form of a mixture of two or more kinds.

Subsequently, the polymerization is carried out by a method in which the substrate 1 having the first electrode (transparent conductive film) 2, the barrier layer 3 and the photoelectric conversion layer 6 formed thereon is immersed in this solution for electrolytic polymerization and the direct current electrolysis is conducted using the photoelectric conversion layer 6 as a working electrode, a platinum wire, platinum plate or the like as a counter electrode and Ag/AgCl, $Ag/AgNO_3$ or the like as a reference electrode. The concentration of the monomer or a multimer thereof in the solution for electrolytic polymerization is not particularly limited, but it is suitably approximately from 0.1 to 1000 mmol/L, more preferably approximately from 1 to 100 mmol/L and even more preferably approximately from 5 to 20 mmol/L. The concentration of the supporting electrolyte is suitably approximately from 0.01 to 10 mol/L and more preferably approximately from 0.1 to 2 mol/L. In addition, the applied current density is desirably in the range of from 0.01 $mA/cm^2$ to 1000 $mA/cm^2$ and more desirably in the range of from 1 $mA/cm^2$ to 500 $mA/cm^2$ in particular. The holding voltage is preferably from -0.5 to +0.2 V and more preferably from -0.3 to 0.0 V. The temperature range of the solution for electrolytic polymerization is properly the range in which the solvent is not solidified and does not bump, and it is generally from -30°C to 80°C. Meanwhile, the conditions such as the electrolytic voltage, the electrolytic current, the time for electrolysis and the temperature depend on the material used, and thus it can be appropriately selected according to the film thickness

to be required.

It is difficult to confirm the degree of polymerization of the polymer for the polymer obtained by electrolytic polymerization, but the solubility of the charge transport layer formed after the polymerization in the solvent greatly decreases, and thus the method to confirm whether it is a polymer or not is as follows. The charge transport layer is immersed in tetrahydrofuran (THF) that is a solvent capable of dissolving the monomer corresponding to a repeating unit (1) of Formula (1), the compound of Formula (10) or a multimer of the compound and the solubility thereof is measured to confirm.

Specifically, the compound is defined to be polymerized in a case in which the compound dissolved is 5 mg or less when 10 mg of the compound (polymer) is introduced into a 25 ml sample bottle, 10 ml of THF is added thereto, and the mixture is irradiated with an ultrasonic wave (25 kHz, 150 W, COLLECTOR CURRENT 1.5A manufactured by Ultrasonic Engineering Co. , Ltd., 150 manufactured by Ultrasonic Engineering Co., Ltd.) for 5 minutes.

Preferably, the solubility when the charge transport layer is immersed in tetrahydrofuran (THF) is from 0.1 to 3 mg.

On the other hand, in the case of conducting the chemical polymerization using a polymerization catalyst, for example, it is possible to polymerize the monomer represented by Formula (10) above, a multimer thereof or the like using a polymerization catalyst as to be described below.

The polymerization catalyst is not particularly limited, but examples thereof may include iron(III) chloride, iron(III) tris-p-toluenesulfonate, iron(III) p-dodecylbenzenesulfonate, iron(III) methanesulfonate, iron(III) p-ethylbenzenesulfonate, iron(III) naphthalenesulfonate and hydrates thereof.

In addition, a polymerization velocity modifier may be used for the chemical polymerization in addition to the polymerization catalyst. The polymerization velocity modifier is not particularly limited, but there is a weak complexing agent for the trivalent iron ion in the polymerization catalyst, and the modifier is not particularly limited as long as a modifier decreases the polymerization velocity so that the film can be formed. For example, in a case in which the polymerization catalyst is iron(III) chloride and its hydrate, an aromatic oxysulfonic acid such as such 5-sulphosalicylic acid, and the like are mentioned. In addition, in a case in which the polymerization catalyst is iron(III) tris-p-toluenesulfonate, iron(III) p-dodecylbenzenesulfonate, iron(III) methanesulfonate, iron(III) p-ethylbenzenesulfonate, iron(III) naphthalenesulfonate and hydrates thereof, imidazole and the like are mentioned.

The polymer may be contained in the coating liquid containing a polymer and supplied onto the photoelectric conversion layer after being synthesized, but a preferred aspect is that the polymer is polymerized on the photoelectric conversion layer to form a charge transport layer. In other words, it is preferable that the polymerization of the monomers or their multimers be conducted on the photoelectric conversion layer.

In this case, a charge transport layer forming solution containing the monomer of Formula (10) above or a multimer thereof or the like, a supporting electrolyte or a polymerization catalyst, a polymerization velocity modifier, other additives and a solvent is used. As the solvent for the charge transport layer forming solution, it is possible to use those exemplified as the solvent for the solution for electrolytic polymerization.

The concentration of the sum of each of the above respective components in the charge transport layer forming solution varies depending on the kind and amount ratio of each of the monomer of Formula (10) above or the multimer thereof or the like, the polymerization catalyst, the polymerization velocity modifier and other additives which are used, the conditions for the coating method and the desired film thickness after the polymerization, but the mass concentration (concentration of solid matter) thereof is roughly in the range of from 1 to 50% by mass.

The polymerization reaction is conducted after the charge transport layer forming solution is coated on the photoelectric conversion layer by a coating method or while the photoelectric antipathy layer is immersed in the charge transport layer forming solution.

The conditions for the polymerization reaction vary depending on the kind, amount ratio and concentration of each of the monomer of Formula (10) above or the multimer thereof or the like, the polymerization catalyst and the polymerization velocity modifier which are used, the thickness of the liquid film at the stage of being coated and the desired polymerization velocity, but a suitable polymerization condition is preferably that the heating temperature is in the range of from 25 to 120°C and the heating time is in the range of from 1 minute to 24 hours in the case of heating in the air.

The method of coating is not particularly limited, and a coating method known in the art can be used as it is or after being appropriately modified. Specifically, it is possible to use various kinds of coating methods such as dipping (immersing), dropping, doctor blade, spin coating, brush coating, spraying, roll coater, air knife coating, curtain coating, wire bar coating, gravure coating, extrusion coating using a hopper described in US 2,681,294 and a simultaneous multilayer coating method described in US 2,761,418, US 3,508,947 and US 2,761,791. In addition, such a coating operation may be repeated so as to laminate. The number of coating in this case is not particularly limited, and it can be appropriately selected according to the desired thickness of the charge transport layer.

The content of the polymerized substance formed by polymerizing the compound represented by Formula (10) or a multimer of the compound in the charge transport layer is not particularly limited. The content is preferably from 50 to 100% by mass and even more preferably from 90 to 100% by mass with respect to the entire monomers in consideration of the hole transport properties and the suppression and prevention ability on the extinction of excitons generated in the

vicinity of the interface of the photoelectric conversion layer.

The polymer is preferably subjected to hole doping in order to increase the conductivity of the charge transport layer. At this time, the hole doping amount is not particularly limited, but it is preferably from 0.15 to 0.66 (pieces) per the compound of Formula (10).

In the electrolytic polymerization, hole doping is conducted by applying an electric field to a polymer having a structure derived from the compound represented by Formula (10) to oxidize it.

In addition, it is preferable that the ionization potential of the polymer used in the invention be less than that of the dye adsorbed electrode in order to reduce the oxidized sensitizing dye of the photoelectric conversion layer. The preferred range of ionization potential of the polymer is not particularly limited and the ionization potential varies depending on the sensitizing dye used, but it is preferably 4.5 eV or more and 5.5 eV or less and even more preferably 4.7 eV or more and 5.3 eV or less in the state of being doped.

In addition, a preferred absorbance as a charge transport layer is preferably 1.0 or less since the loss of light due to absorption is less and the degradation due to light is suppressed when the visible light absorptance is low. In addition, the absorbance slightly increases as the degree of polymerization of the polymer increases, and a charge transport layer having a degree of polymerization at which the absorbance is 0.2 or more is preferable as the absorbance in order to have a degree of polymerization exhibiting preferred hole transport capability. Hence, it is preferable that the polymer according to the invention have an absorbance of from 0.2 to 1.0 at from 400 to 700 nm (average value of absorbance in the wavelength region of from 400 to 700 nm).

In the present specification, the absorbance of the charge transport layer (polymer) is defined using the absorbance difference of the working electrode before and after electrolytic polymerization, and at this time, the absorbance means the average value of absorbance in the wavelength region of from 400 to 700 nm. The absorbance is measured using a spectrophotometer (JASCO V-530). As the working electrode, the resultant obtained by adsorbing a dye on the titanium oxide thin film which is formed on a FTO conductive glass substrate and has an effective area of $10 \times 20$ $mm^2$, the working electrode is immersed in a solution having the same composition as the solution for electrolytic polymerization described above, a polymer having a repeating unit of Formula (1) or Formula (10) is formed on the working electrode by holding the voltage for 30 minutes using a platinum wire as the counter electrode and $Ag/Ag^+$ (0.01 M of $AgNO_3$) as the reference electrode at the holding voltage of -0.16 V while irradiating with light from the semiconductor layer direction (a xenon lamp used, light intensity of 22 $mW/cm^2$, wavelength of 430 nm or less cut), and the absorbance is measured. In order to correct the effect of variation in the film thickness, a value obtained by measuring the film thickness of the sample and dividing it by the film thickness ($\mu$m). The measurement of film thickness is conducted using Dektak3030 (manufactured by SLOAN TECHNOLOGY Co.).

[Second electrode]

The second electrode is disposed so as to come in contact with the charge transport layer and can be composed of an arbitrary conductive material. An insulating material can also be used as long as a conductive material layer is provided on the side facing the charge transport layer thereof. It is preferable that the contact between the second electrode and the charge transport layer be favorable from the viewpoint of decreasing the electrical resistance of the element, and the like. In addition, it is preferable that the difference in work function between the second electrode and the charge transport layer be small and the second electrode be chemically stable. Such a material is not particularly limited, but examples thereof may include a thin film of a metal such as gold, silver, copper, aluminum, platinum, chromium, rhodium, ruthenium, magnesium and indium and an organic conductor such as carbon, carbon black, a conductive macromolecule and a conductive metal oxide (indium-tin composite oxide, fluorine doped tin oxide and the like). A thin film of a metal such as gold is preferable. In addition, the thickness of the second electrode is not particularly limited, but it is preferably from 10 to 1000 nm. In addition, the surface resistance value of the second electrode is not particularly limited, and it is preferably as low as possible. Specifically, the surface resistance value is preferably 80 $\Omega/cm^2$ or less and more preferably 20 $\Omega/cm^2$ or less. Meanwhile, the lower limit of the surface resistance of the second electrode is not necessary to be particularly defined since it is preferably as low as possible, but it is sufficiently 0.01 $\Omega/cm^2$ or more.

In addition, it is also possible to use one obtained by forming the metal thin film on a glass substrate as the second electrode.

When the photoelectric conversion element having the configuration as described above is irradiated with light from the outside of the substrate, the sensitizing dye supported on the semiconductor layer of the photoelectric conversion layer in the inside of the element is excited to emit electrons. The excited electrons are injected into the semiconductor and move to the first electrode through the barrier layer. The electrons moved to the first electrode move to the second electrode through the external circuit and are supplied to the charge transport layer. Incidentally, the oxidized sensitizing dye (after emitting electrons) receives electrons from the charge transport layer to return to the ground state. Light is converted into electricity as such a cycle is repeated.

In the photoelectric conversion element according to the invention, the conjugation length is extended and the

resonance stability is improved as $Ar_1$ is present in the compound of Formula (1), moreover, X and Y are present apart from each other, the charge injection into the oxide semiconductor is efficiently performed, and the sensitizing dye shows a wide absorption peak including visible light of sunlight, and as a result, the photoelectric conversion efficiency for sunlight can be improved. In other words, the photoelectric conversion element according to the invention exhibit excellent photoelectric conversion efficiency.

<Solar cells>

The photoelectric conversion element according to the invention can be particularly suitably used in a solar cell. Accordingly, the invention also provides a solar cell which is characterized by including the photoelectric conversion element described above.

The photoelectric conversion element according to the invention can be used as a dye-sensitized solar cell. In other words, the solar cell according to the invention includes a plurality of solar cells (photoelectric conversion element according to the invention) which are electrically connected to one another, for example, by an interconnector, a pair of protective members sandwiching them, and a sealing resin filled in the gap between the pair of protective members and the plurality of solar cells. One of the pair of protective members is a substrate of the photoelectric conversion element described above. Both of the pair of protective members may be transparent or only one of them may be transparent.

Examples of the structure of the solar cell according to the invention may include a Z-type module and a W-type module. The Z-type module has a structure in which a porous semiconductor layer supporting a plurality of dyes is formed on one protective member of the pair of facing protective members, a plurality of charge transport layers are formed on the other substrate, and these are pasted to each other. The W-type module has a structure in which a laminate of a porous semiconductor layer supporting a dye and a charge transport layer is formed at every other position on each of the protective members and the protective members pasted to each other such that the cells are alternate with each other.

When the solar cell according to the invention is irradiated with sunlight or electromagnetic waves equivalent to sunlight, the sensitizing dye supported on the semiconductor absorbs the irradiated light or electromagnetic waves to be excited. The electrons generated by the excitation move to the semiconductor, subsequently move to the second electrode via the conductive support and the external load, and are supplied to the charge (hole) transport material of the charge transport layer. On the other hand, the sensitizing dye from which the electrons have moved to the semiconductor has become an oxidized substance but is reduced to return to the original state as the electrons are supplied from the second electrode via the polymer of the charge transport layer, and at the same time, the polymer of the charge transport layer is oxidized and returns to the state of being able to be reduced again by the electrons supplied from the second electrode. The electrons flow in this manner, and thus it is possible to configure the solar cell using the photoelectric conversion element of the invention.

EXAMPLES

Hereinafter, the invention will be described with reference to Examples, but the invention is not limited thereto.

[Synthesis Example 1: Synthesis of Compound 2]

Compound 2 was synthesized by the following scheme.

[Chem. 17]

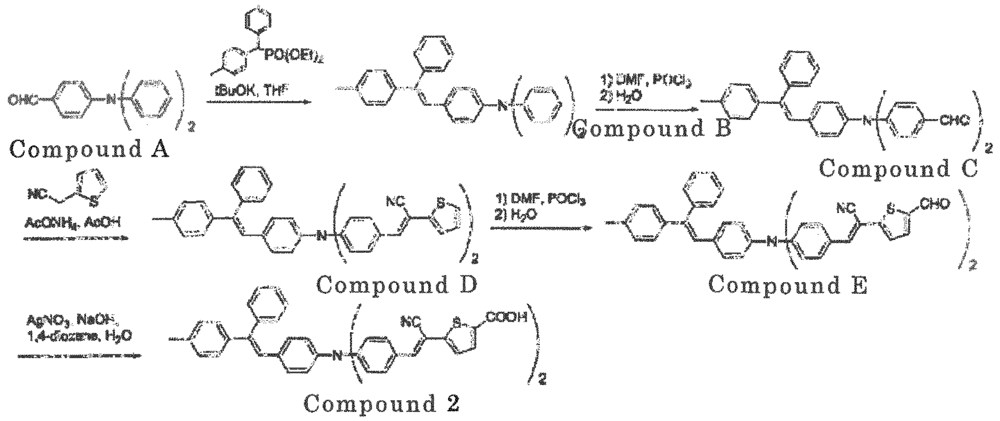


Compound A

Compound B

Compound C

Compound D

Compound E

Compound 2

To 0°C, 1 equivalent of a THF solution of diethyl phenyl (p-tolyl) methylphosphonate was cooled with ice, 1.1 equivalents of potassium tert-butoxide was added thereto, the mixture was stirred for 30 minutes, 1 equivalent of 4-(diphenylamino) benzaldehyde (Compound A) was then added thereto at 0°C and the mixture was stirred for 3 hours after raising the temperature to 50°C. The reaction mixture was extracted with ethyl acetate, and the extraction liquid was washed with water and dried over magnesium sulfate. The solvent of the extraction liquid thus obtained was distilled off by a rotary evaporator, and the resultant was purified by silica gel column chromatography, thereby obtaining Compound B.

A DMF solution of Compound B was cooled with ice to 0°C, 3 equivalents of phosphorus oxychloride was added dropwise thereto, the mixture was stirred at 60°C for 3 hours and then cooled to 0°C, an excess amount of cold water was added thereto in the state of being vigorously stirred, then the mixture was heated to 20°C and stirred for 2 hours. The reaction mixture was extracted with ethyl acetate, and extraction liquid was washed with water and dried over magnesium sulfate. The solvent of the extraction liquid thus obtained was distilled off by a rotary evaporator, and the resultant was purified by silica gel column chromatography, thereby obtaining Compound C.

Compound C was suspended in acetic acid, 2.2 equivalents of thiophene-2-acetonitrile and 2.2 equivalents of ammonium acetate were added thereto and the mixture was stirred at 100°C for 5 hours. The reaction mixture was extracted with ethyl acetate, and extraction liquid was washed with water and dried over magnesium sulfate. The solvent of the extraction liquid thus obtained was distilled off by a rotary evaporator, and the resultant was purified by silica gel column chromatography, thereby obtaining Compound D.

A DMF solution of Compound D was cooled with ice to 0°C, 2.2 equivalents of phosphorus oxychloride was added dropwise thereto, the mixture was stirred at 60°C for 2 hours and then cooled to 0°C, an excess amount of cold water was added thereto in the state of being vigorously stirred, then the mixture was heated to 20°C and stirred for 2 hours. The reaction mixture was extracted with ethyl acetate, and extraction liquid was washed with water and dried over magnesium sulfate. The solvent of the extraction liquid thus obtained was distilled off by a rotary evaporator, and the resultant was purified by silica gel column chromatography, thereby obtaining Compound E.

To 6 equivalents of an aqueous solution of sodium hydroxide, 3 equivalents of an aqueous solution of silver nitrate was added dropwise, the mixture was stirred for 30 minutes, a 1,4-dioxane : THF = 1 : 1 solution of Compound E was then added dropwise thereto, and the mixture was stirred at 45°C For 8 hours. The solution was filtered through Celite, 1,4-dioxane and THF were then removed therefrom under reduced pressure, and the pH of the resultant was adjusted to 4 with 0.1 N hydrochloric acid, the resultant was extracted with ethyl acetate and dried over magnesium sulfate. The solvent of the extraction liquid thus obtained was distilled off by a rotary evaporator, thereby obtaining Compound 2.

The structure of Compound 2 was confirmed by the nuclear magnetic resonance spectrum and the mass spectrum.

[Synthesis Example 2: Synthesis of Compound 3]

Compound 3 was synthesized by the following scheme.

[Chem. 18]

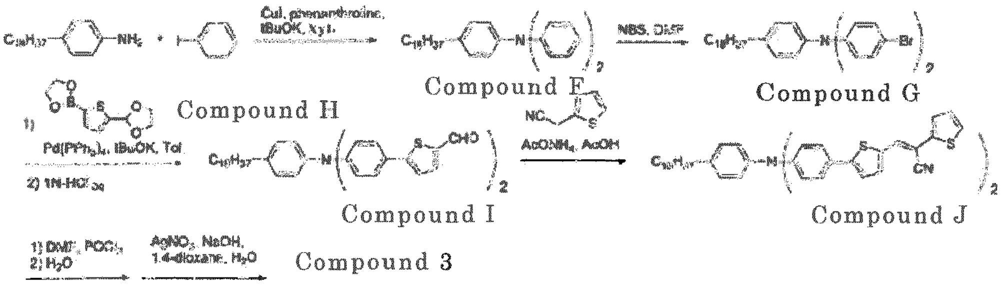


To 1 equivalent of a xylene solution of 4-octadecylaniline, 2.2 equivalents of iodobenzene, 0.1 equivalent of copper iodide, 0.3 equivalent of phenanthroline, 4.4 equivalents of potassium tert-butoxide were added and the mixture was stirred at 170°C for 3 hours. Thereafter, the liquid temperature was cooled to room temperature, the liquid was then filtered through Celite, xylene was distilled off therefrom under reduced pressure, and a toluene solution of the resultant was prepared, and extraction liquid was washed with water and dried over magnesium sulfate. The solvent of the extraction liquid thus obtained was distilled off by a rotary evaporator, and the resultant was purified by silica gel column chromatography, thereby obtaining Compound F.

A DMF solution of Compound F was cooled with ice to 0°C, 2.2 equivalents of N-bromosuccinimide was added thereto, and the mixture was stirred at room temperature for 1 hour. Water was added to the reaction mixture, the reaction mixture was extracted with ethyl acetate, and extraction liquid was washed with water and dried over magnesium sulfate. The solvent of the extraction liquid thus obtained was distilled off by a rotary evaporator, and the resultant was purified by silica gel column chromatography, thereby obtaining Compound G.

To a toluene solution of Compound G, 2.2 equivalents of Compound H, 0.2 equivalent of tetrakis(triphenylphosphine)palladium and 4.4 equivalents of potassium tert-butoxide were added, and the mixture was stirred at 80°C for 6 hours. The reaction mixture was cooled to room temperature, filtered through Celite, the extraction liquid was washed with water and saturated saline solution and then dried over magnesium sulfate. The solvent of the extraction liquid thus obtained was distilled off by a rotary evaporator, and the resultant was purified by silica gel column chromatography, thereby obtaining Compound I.

Compound 3 was obtained by conducting the addition of thiophene-2-acetonitrile, the formylation of thiophene and the carboxylation of formyl in the same manner as in Synthesis Example 1 except that Compound I obtained above was used instead of Compound C in Synthesis Example 1 above.

The structure of Compound 3 was confirmed by the nuclear magnetic resonance spectrum and the mass spectrum.

[Synthesis Example 3: Synthesis of Compound 5]

Compound 5 was synthesized by the following scheme.

[Chem. 19]

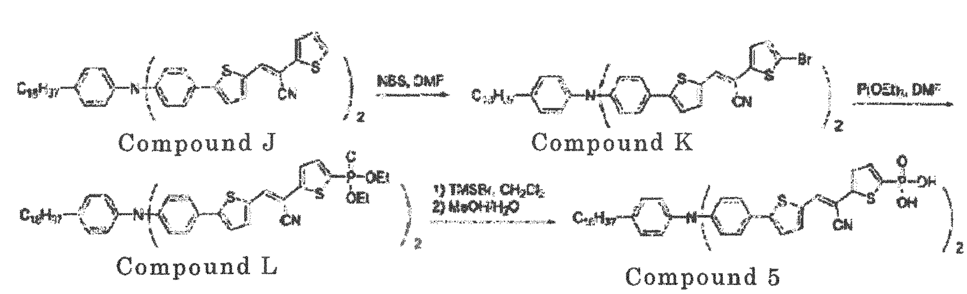


Compound J was synthesized in the same manner as in Synthesis Example 2. A DMF solution of this Compound J was cooled with ice to 0°C, 2.2 equivalents of N-bromosuccinimide was added, and the mixture was stirred at room temperature for 1 hour. Water was added to the reaction mixture, the reaction mixture was extracted with ethyl acetate, and extraction liquid was washed with water and dried over magnesium sulfate. The solvent of the extraction liquid thus obtained was distilled off by a rotary evaporator, and the resultant was purified by silica gel column chromatography,

thereby obtaining Compound K.

To a DMF solution of Compound K, 3 equivalents of triethyl phosphite was added, and the mixture was stirred at 100°C for 5 hours, subsequently subjected to the distillation under reduced pressure, the residue was dissolved in ethyl acetate, the solution washed with water and then dried over magnesium sulfate. The solution was distilled off by a rotary evaporator, thereby obtaining Compound L.

A dichloromethane solution of Compound L was cooled to 0°C, 5 equivalents of bromidetrimethylsilane was added thereto, the mixture was stirred for 2 hours, the solvent was distilled off under reduced pressure, a methanol : water = 19 : 1 solution was added to the residue, and the mixture was stirred for 12 hours. The solvent was distilled off under reduced pressure, the residue was dissolved in ethyl acetate, and the organic layer was extracted by adding 1 N hydrochloric acid, and extraction liquid was washed with water and then dried over sodium sulfate. The solution was distilled off by a rotary evaporator, thereby obtaining Compound 5.

The structure of Compound 5 was confirmed by the nuclear magnetic resonance spectrum and the mass spectrum.

[Synthesis Example 4: Synthesis of Compound 21]

Compound 21 was synthesized by the following scheme.

[Chem. 20]

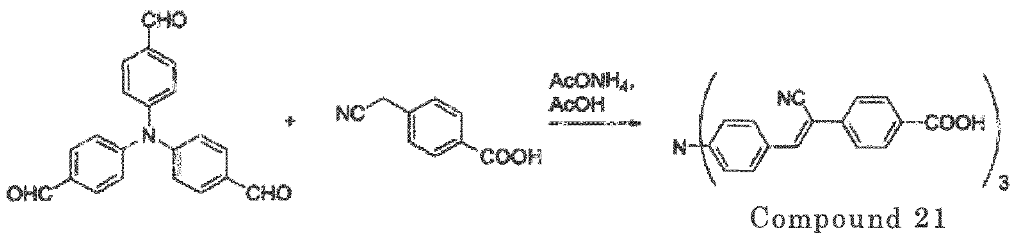


Compound 21

To an acetic acid : 1,4-dioxane = 1 : 1 solution of 1 equivalent of tri- (4-formylphenyl)-amine and 3.3 equivalents of 4-(cyanomethyl)benzoic acid, 1 equivalent of ammonium acetate was added and the mixture was stirred at 105°C for 8 hours. The resultant was subjected to the distillation under reduced pressure to room temperature, a suspension was prepared by adding water to the residue, the solid matter was then taken by Kiriyama filtration, the resultant was washed with water until the odor of acetic acid disappeared, and subsequently washed with cold ethyl acetate, thereby obtaining Compound 21.

The structure of Compound 21 was confirmed by the nuclear magnetic resonance spectrum and the mass spectrum.

[Synthesis Examples 5 to 25]

Compounds 5 to 25 according to the invention were synthesized by appropriately combining the electrophilic aromatic substitution reaction, the nucleophilic aromatic substitution reaction, the coupling reaction, a metathesis reaction and the like with the synthetic method of Synthesis Example 1.

[Synthesis Examples 26 and 27]

Compounds 101 and 102 were synthesized by appropriate combining chemical reactions in the same manner as the above. Compounds 101 and 102 are presented below.

[Chem. 21]

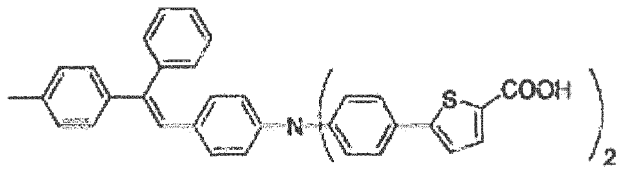

Compound 101

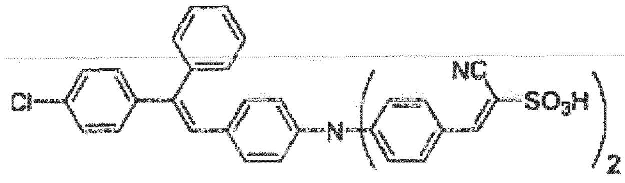

Compound 102

[Example 1: Fabrication of photoelectric conversion element 1]

A titanium oxide paste (anatase type, primary average particle size (average of microscopic observation) of 18 nm, dispersed in polyethylene glycol) was coated on a fluorine doped tin oxide (FTO) conductive glass substrate (glass substrate thickness: 1.1 mm, manufactured by Nippon Sheet Glass Co., Ltd.) (coating amount of FTO: 7 g/$m^2$ glass substrate, thickness of FTO: 900 nm) by a screen printing method (coating area 5 $\times$ 5 $mm^2$). Coating and drying (120°C for 3 minutes) were repeated two times and calcination was conducted at 200°C for 10 minutes and at 500°C for 15 minutes, thereby obtaining a titanium oxide thin film (porosity C of barrier layer: 1% by volume) having a thickness of 6 $\mu$m. On this thin film, a titanium oxide paste (anatase type, primary average particle size (average of microscopic observation) of 400 nm, dispersed in polyethylene glycol) was further coated and calcined by the same method to form a titanium oxide thin film (porosityDof semiconductor layer: 50% by volume) having a thickness of 3 $\mu$m (FTO glass substrate having titanium oxide coated thereon and sintered).

Compound 1 (sensitizing dye) of the invention was dissolved in a mixed solvent of acetonitrile : t-butyl alcohol = 1 : 1 to prepare a 5 $\times$ $10^{-4}$ mol/l solution. The FTO glass substrate having titanium oxide coated thereon and sintered was immersed in this solution at room temperature for 3 hours to conduct the adsorption treatment of the dye, thereby obtaining a photoelectric conversion layer (semiconductor electrode). Meanwhile, the total supported amount of the sensitizing dye per 1 $m^2$ of the semiconductor layer of the photoelectric conversion layer thus obtained was 1.2 mmol.

As the charge transport layer (electrolyte), an acetonitrile : valeronitrile = 85 : 15 solution containing 1-methyl-3-butylimidazolium iodide at 0.6 mol/l, guanidine thiocyanate at 0.1 mol/l, iodine at 0.05 mol/l and 4-(t-butyl) pyridine at 0.5 mol/l was used. As the counter electrode, a glass plate having platinum and chromium deposited thereon (platinum and chromium deposited layer: 10 nm) was used, and the semiconductor electrode and the charge transport layer which were previously fabricated and the counter electrode were assembled using the clamping cell, thereby fabricating the photoelectric conversion element 1.

[Examples 2 to 13: Fabrication of photoelectric conversion elements 2 to 13]

The photoelectric conversion elements 2 to 13 were fabricated in the same manner as in Example 1 except that the compounds which were synthesized in Synthesis Examples and presented in Table were used as the sensitizing dye.

[Example 14: Fabrication of photoelectric conversion element 14]

The FTO glass substrate having titanium oxide coated thereon and sintered was formed in the same manner as in Example 1.

Compound 1 (sensitizing dye) of the invention was dissolved in a mixed solvent of acetonitrile : t-butyl alcohol = 1 : 1 (volume ratio) to prepare a solution containing a sensitizing dye at 5 $\times$ $10^{-4}$ mol/L. The FTO glass substrate having titanium oxide coated thereon and sintered was immersed in this solution at room temperature (25°C) for 3 hours to conduct the adsorption treatment of the sensitizing dye on the semiconductor, thereby obtaining a photoelectric conversion layer (semiconductor electrode). Meanwhile, the total supported amount of the sensitizing dye per 1 $m^2$ of the semiconductor layer of the photoelectric conversion layer thus obtained was 1.2 mmol.

The electrolytic polymerization was immersed in an acetonitrile solution (concentration of charge transport

material: 1 × $10^{-3}$ mol/L, concentration of $Li[(CF_3SO_2)_2N]$ : 0.1 mol/L) containing 2,2'-bis-3,4-ethylenedioxythiophene of the monomer to be a raw material of the charge transport material and $Li[(CF_3SO_2)_2N]$. The above semiconductor electrode was used as the working electrode, a platinum wire was used as the counter electrode, $Ag/Ag^+$ (0.01 M of $AgNO_3$) was used as the reference electrode, and the holding voltage was set to -0.3 V. The charge transport layer was formed on the surface of the semiconductor electrode by holding the voltage for 15 minutes while irradiating with light from the semiconductor layer direction (a xenon lamp used, light intensity of 32 mW/$cm^2$, a wavelength of 520 nm or less cut). The semiconductor electrode/charge transport layer thus obtained was washed with acetonitrile, and dried.

Meanwhile , the charge transport layer obtained here is a polymerized film that is insoluble in a solvent. Thereafter, the charge transport layer was immersed in a chlorobenzene : acetonitrile = 19 : 1 solution containing $Li[(CF_3SO_2)_2N]$ and tert-butylpyridine at the proportion of 15 × $10^{-3}$ mol/L and 50 × $10^{-3}$ mol/L, respectively for 30 minutes. Subsequently, gold (Au) was deposited thereon by 90 nm by a vacuum deposition method, thereby fabricating the second electrode, whereby the photoelectric conversion element 14 was fabricated.

[Examples 15 to 20: Fabrication of photoelectric conversion elements 15 and 20]

The photoelectric conversion elements 15 to 20 were fabricated in the same manner as in Example 14 except that the compounds which were synthesized in Synthesis Examples and presented in Table were used as the sensitizing dye.

[Comparative Examples 1 and 2: Fabrication of photoelectric conversion elements 21 and 22]

The photoelectric conversion elements 21 and 22 were fabricated in the same manner as in Example 1 except that Compounds 101 and 102 synthesized in Synthesis Examples were used as the sensitizing dye.

[Comparative Examples 3 and 4: Fabrication of photoelectric conversion elements 23 and 24]

The photoelectric conversion elements 23 and 24 were fabricated in the same manner as in Example 13 except that Compounds 101 and 102 synthesized in Synthesis Examples were used as the sensitizing dye.

[Evaluation of photoelectric conversion element]

<Measurement of photoelectric conversion efficiency>

The photoelectric conversion element was irradiated with simulated sunlight having an intensity of 100 mW/$cm^2$ from a xenon lamp through an AM filter (AM-1.5) using a solar simulator (manufactured by EKO INSTRUMENTS CO., LTD.). Thereafter, the current-voltage properties of the photoelectric conversion element at room temperature (25°C) was measured using a I-V tester, and the short circuit current density (Jsc), the open circuit voltage (Voc) and the fill factor (F.F.) were measured. The photoelectric conversion efficiency η (%) was calculated by the following Equation 1 based on these values.

[Mathematical Formula 1]

[Equation 1]

$$\eta = [(Voc \times Jsc \times F.F.)/P] \times 100$$

P: Intensity of incident light [mW·$cm^{-2}$]
Voc: Open circuit voltage [V]
Jsc: Short circuit current density [mA·$cm^{-2}$]
F.F.: Fill factor

The evaluation results of the above test for Examples 1 to 20 and Comparative Examples 1 to 4 are presented in Table 1.

[Table 1]

[Table 1]

| | Photoelectric conversion element | Sensitizing dye | Voc (mV) | Jsc (mA) | η (%) |
|---|---|---|---|---|---|
| Example 1 | 1 | Compound 1 | 720 | 6.8 | 3.3 |
| Example 2 | 2 | Compound 2 | 710 | 7.5 | 3.6 |
| Example 3 | 3 | Compound 3 | 720 | 8.5 | 4.3 |
| Example 4 | 4 | Compound 5 | 710 | 8.4 | 4.2 |
| Example 5 | 5 | Compound 6 | 700 | 8.6 | 4.2 |
| Example 6 | 6 | Compound 8 | 730 | 6.7 | 3.5 |
| Example 7 | 7 | Compound 11 | 760 | 5.9 | 3.1 |
| Example 8 | 8 | Compound 12 | 690 | 6.3 | 2.9 |
| Example 9 | 9 | Compound 15 | 670 | 5.3 | 2.4 |
| Example 10 | 10 | Compound 16 | 730 | 7.4 | 3.8 |
| Example 11 | 11 | Compound 20 | 710 | 7.8 | 4.0 |
| Example 12 | 12 | Compound 22 | 720 | 5.7 | 2.7 |
| Example 13 | 13 | Compound 25 | 730 | 5.5 | 2.7 |
| Comparative Example 1 | 21 | Compound 101 | 670 | 4.1 | 1.9 |
| Comparative Example 2 | 22 | Compound 102 | 650 | 3.1 | 1.4 |
| Example 14 | 14 | Compound 2 | 780 | 6.8 | 3.5 |
| Example 15 | 15 | Compound 3 | 820 | 7.4 | 4.3 |
| Example 16 | 16 | Compound 5 | 810 | 7.2 | 4.1 |
| Example 17 | 17 | Compound 6 | 800 | 7.9 | 4.2 |
| Example 18 | 18 | Compound 11 | 810 | 5.3 | 2.9 |
| Example 19 | 19 | Compound 20 | 780 | 6.9 | 3.8 |
| Example 20 | 20 | Compound 25 | 800 | 4.8 | 2.6 |
| Comparative Example 3 | 23 | Compound 101 | 720 | 3.3 | 1.7 |
| Comparative Example 4 | 24 | Compound 102 | 690 | 2.1 | 1.0 |

## Claims

1. A photoelectric conversion element comprising a substrate, a first electrode, a photoelectric conversion layer containing a semiconductor and a sensitizing dye, a charge transport layer, and a second electrode, wherein the sensitizing dye is represented by the following Formula (1):

[Chem. 1]

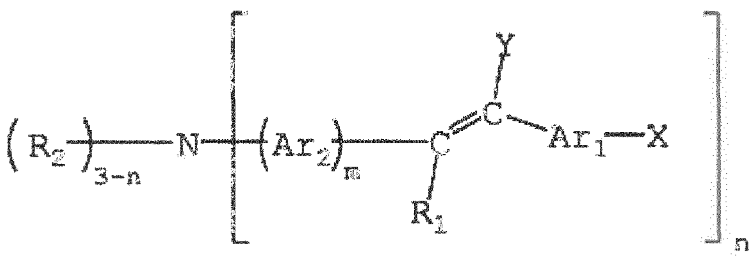

(1)

wherein in the Formula (1),

$Ar_1$ represents a substituted or unsubstituted divalent aromatic group or heterocyclic group;
X represents a carboxylic acid group (-C(=O)(OH)), a sulfonic acid group ($-S(=O)_2(OH)$), a phosphoric acid group ($-O-P(=O)(OH)_2$) or a phosphinic acid group ($-PR_a(=O)(OH)$, $R_a$ represents a hydrogen atom or an alkyl group having 1 to 24 carbon atoms);
Y represents a cyano group, a nitro group, a halogen atom, $-COR_b$, $-COOR_b$ or $-S(=O)_2R_b$ (wherein $R_b$ represents a hydrogen atom, a substituted or unsubstituted alkyl group having 1 to 24 carbon atoms, a substituted or unsubstituted alkenyl group having 2 to 24 carbon atoms, a substituted or unsubstituted alkynyl group having 2 to 24 carbon atoms, a substituted or unsubstituted aryl group having 6 to 24 carbon atoms, a substituted or unsubstituted acyl group having 1 to 24 or a substituted or unsubstituted heterocyclic group or an amino group) ;
$R_1$'s each independently represent a hydrogen atom or a substituted or unsubstituted alkyl group having 1 to 24 carbon atoms;
$Ar_2$'s each independently represent a divalent aromatic ring-containing group or heterocyclic ring-containing group;
m represents an integer of 0 or more;
$R_2$'s each independently represent a substituted or unsubstituted alkyl group having 1 to 24 carbon atoms, a substituted or unsubstituted cycloalkyl group having from 3 to 24 carbon atoms, a substituted or unsubstituted alkenyl group having 2 to 24 carbon atoms, a substituted or unsubstituted alkynyl group having 2 to 24 carbon atoms, a substituted or unsubstituted hydrocarbon ring-containing group having 6 to 24 carbon atoms or a substituted or unsubstituted heterocyclic ring-containing group;
n is 2 or 3; and
$Ar_1$ and $Ar_2$ at each end of the carbon-carbon double bond may be in either a cis relation or a trans relation.

**2.** The photoelectric conversion element according to claim 1, wherein in the Formula (1), n is 2.

**3.** The photoelectric conversion element according to claim 2, wherein the Formula (1) is represented by the following Formula (2):

[Chem. 2]

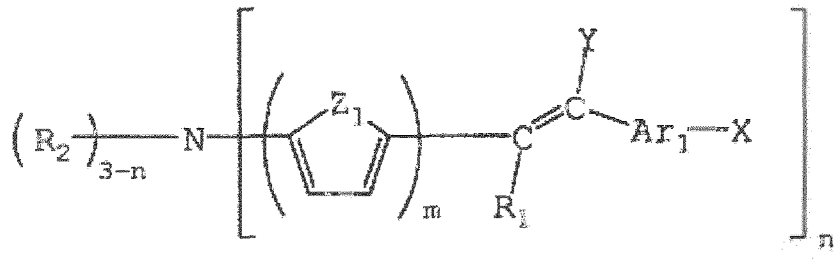

(2)

wherein in the Formula (2),

$Ar_1$, $R_1$, $R_2$, X, Y and m are as defined in the Formula (1);
n is 2;
$Z_1$ represents S or C=C; and
$R_1$ and Y at each end of the carbon-carbon double bond may be in either a cis relation or a trans relation.

**4.** The photoelectric conversion element according to claim 2 or 3, wherein the Formula (1) is represented by the following Formula (3):

[Chem. 3]

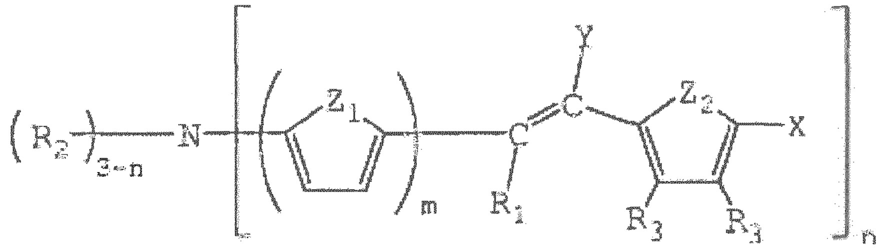

(3)

wherein in the Formula (3),

$R_1$, $R_2$, X, Y and m are as defined in the Formula (1) ;
n is 2;
$Z_1$ and $Z_2$ each independently represent S or C=C;
$R_3$' s each independently represent a hydrogen atom, a substituted or unsubstituted alkyl group having 1 to 24 carbon atoms, a substituted or unsubstituted alkenyl group having 2 to 24 carbon atoms, a substituted or unsubstituted alkynyl group having 2 to 24 carbon atoms, a substituted or unsubstituted alkoxy group having 1 to 24 carbon atoms, a substituted or unsubstituted aryl group having 6 to 24 carbon atoms or a substituted or unsubstituted heterocyclic group, and two $R_3$'s may be joined to each other to form a ring; and
$R_1$ and Y at each end of the carbon-carbon double bond may be in either a cis relation or a trans relation.

5. The photoelectric conversion element according to any one of claims 1 to 4, wherein in the Formula (1), X represents a carboxylic acid group.

6. A solar cell comprising the photoelectric conversion element set forth in any one of claims 1 to 5.

FIG. 1

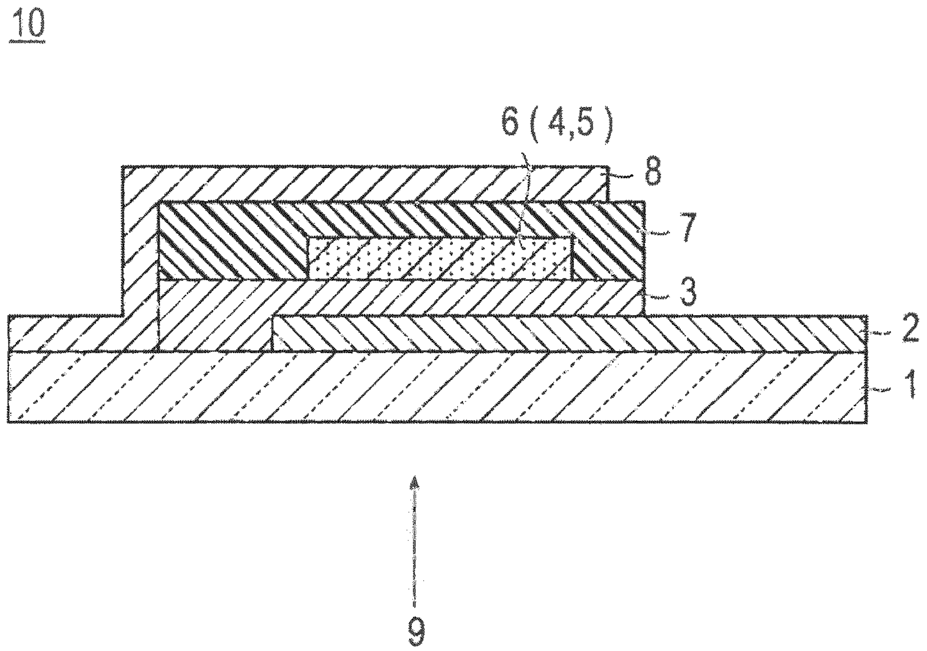

**INTERNATIONAL SEARCH REPORT**

International application No. PCT/JP2014/053102

A. CLASSIFICATION OF SUBJECT MATTER
*H01M14/00*(2006.01)i, *H01L31/04*(2014.01)i

According to International Patent Classification (IPC) or to both national classification and IPC

B. FIELDS SEARCHED

Minimum documentation searched (classification system followed by classification symbols)
H01M14/00, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| P,A | JP 2013-239384 A (Konica Minolta, Inc.), 28 November 2013 (28.11.2013), claims (Family: none) | 1-6 |
| A | MIKROYANNIDIS et al.Low band gap vinylene compounds with triphenylamine and benzothiadiazole segments for use in photovoltaic cells, Organic Electronics, 2009, 10(7), p.1320-1333 | 1-6 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 10 March, 2014 (10.03.14) | 18 March, 2014 (18.03.14) |
| Name and mailing address of the ISA/ Japanese Patent Office | Authorized officer |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 9199744 A
- JP 2006185911 A
- JP 7005706 A
- JP 7005709 A
- US 4684537 A
- US 4927721 A
- US 5084365 A
- US 5350644 A
- US 5463057 A
- US 5525440 A
- JP 7249790 A
- JP 2000150007 A
- JP 2001160427 A
- US 5061569 A
- JP 4308688 A
- JP 2000106223 A
- US 2681294 A
- US 2761418 A
- US 3508947 A
- US 2761791 A


### Non-patent literature cited in the description


- *Journal of the Surface Science Society of Japan,* vol. 21 (5), 288-293
- **J. R. REYNOLDS.** *Adv. Mater.,* 1999, vol. 11, 1379
- **T. M. SWAGER.** *Journal of the American Chemical Society,* 1997, vol. 119, 12568